# EUROPEAN PATENT SPECIFICATION

(11) **EP 4 287 792 B1**
(45) Date of publication and mention of the grant of the patent: **12.08.2026**
(21) Application number: 22746305.6
(22) Date of filing: 28.01.2022
(51) Int. Cl.: H10W 70/60, H05K 3/24, H05K 1/11, H10W 76/60, H10W 72/00, H05K 3/42, H10W 70/685, H10W 99/00, H05K 3/46, H10W 70/05, H10W 90/00

(54) **SEMICONDUCTOR PACKAGE**
HALBLEITERGEHÄUSE
BOÎTIER DE SEMI-CONDUCTEUR

(30) Priority: 01.02.2021 KR 20210013921
(43) Date of publication of application: 06.12.2023
(73) Proprietor: LG Innotek Co., Ltd., Seoul 07796 (KR)
(72) Inventor: KIM, Hong Ik, Seoul 07796 (KR); JOUNG, Dong Hun, Seoul 07796 (KR); LEE, Chung Gi, Seoul 07796 (KR)
(74) Representative: Plasseraud IP
(86) International application number: PCT/KR2022/001651
(87) International publication number: WO 2022/164279

(56) References cited:
- JP-A- 2012 049 423
- KR-A- 20120 094 523
- KR-A- 20190 012 075
- KR-B1- 101 875 943
- KR-B1- 101 956 563
- US-A1- 2008 277 148
- US-A1- 2011 120 762
- US-A1- 2013 119 555
- US-A1- 2014 041 923

## Description

### [Technical Field]

An embodiment relates to a circuit board, and more particularly, to a circuit board including a large-area through electrode and a semiconductor package including the same.

### [Background Art]

A line width of circuits is becoming smaller as the miniaturization, weight reduction, and integration of electronic components accelerate. In particular, as design rules of semiconductor chips are integrated on a nanometer scale, a circuit line width of a package substrate or a circuit board on which a semiconductor chip is mounted is reduced to several micrometers or less.

In order to increase the degree of circuit integration of the circuit board, that is, various methods have been proposed in order to miniaturize the circuit line width. In order to prevent loss of circuit line width in the etching step to form a pattern after copper plating, a semi-additive process (SAP) method and a modified semi-additive process (MSAP) have been proposed.

Since then, in order to realize a finer circuit pattern, an Embedded Trace Substrate (hereinafter referred to as 'ETS') method, which buries and embeds copper foil in an insulating layer, has been used in this technology field. The ETS method is manufactured by embedding the copper foil circuit in the insulating layer instead of forming it on the surface of the insulating layer. For this reason, there is no circuit loss due to etching, so it is advantageous to refine the circuit pitch.

Meanwhile, recently, efforts are being made to develop an improved 5th generation (5G) communication system or a pre-5G communication system in order to meet the demand for wireless data traffic. Here, the 5G communication system uses ultra-high frequency (mmWave) bands (sub 6 gigabytes (6GHz), 28 gigabytes 28GHz, 35 gigabytes 35GHz or higher frequencies) to achieve high data rates.

And, in order to alleviate the path loss of radio waves in the very high frequency band and increase the propagation distance of radio waves, aggregation technologies such as beamforming, massive MIMO, and array antenna are being developed in the 5G communication system. It should be taken into account that these frequency bands can consist of hundreds of active antennas of wavelength, which makes the antenna system relatively large.

These antennas and AP modules are patterned or mounted on a printed circuit board, and for this reason, low loss of the printed circuit board is very important. This means that several substrates constituting an active antenna system, that is, an antenna substrate, an antenna feed substrate, a transceiver substrate, and a baseband substrate must be integrated into one compact unit.

Meanwhile, recently, a circuit board including a through electrode having a large area has been developed in order to improve heat dissipation characteristics or shielding characteristics. A large-area through electrode can be formed by filling a large-diameter through-hole with a metal material. However, it is not easy to fill the inside of the large-diameter through-hole with a metal material, and accordingly, a conventional large-area through electrode includes a dimple region concavely recessed toward the inside of the through-hole on one surface. In addition, the dimple region may affect through-hole processing during additional lamination, thereby affecting the reliability of the printed circuit board. The Patent Application Publication US 2008/277148 A1 discloses a multilayer printed circuit board which can be employed as a package substrate on which electronic elements, such as IC, are mounted. The Patent Application Publication US 2013/119555 A1 discloses the use of glass as the interposer material with the surface of the interposer and/or the walls of through vias in being coated by a stress relief barrier that provides thermal expansion and contraction stress relief and better metallization capabilities. The Patent Application Publication US 2014/041923 A1 discloses a wiring board with a stacked structure and to a method for manufacturing such a wiring board. The Patent Application Publication US 2011 /120762 A1 discloses a printed wiring board having a through-hole conductor formed by filling plating in a penetrating hole in an insulative substrate, and to its manufacturing method

### [Disclosure]

### [Technical Problem]

The embodiment provides a circuit board having a novel structure and a semiconductor package including the circuit board.

The embodiment provides a circuit board having a new structure capable of removing surface stains of an electrode part and a semiconductor package including the same.

The embodiment provides a circuit board having a new structure including a through electrode manufactured by a minimal plating process while simplifying a plating process, and a semiconductor package including the same.

Technical problems to be solved by the proposed embodiments are not limited to the above-mentioned technical problems, and other technical problems not mentioned may be clearly understood by those skilled in the art to which the embodiments proposed from the following descriptions belong.

### [Technical Solution]

A circuit board according to an embodiment is defined in the appended claims.

### [Advantageous Effects]

An embodiment includes a through electrode passing through the insulating layer. In this case, in an embodiment, a plurality of plating processes are performed to fill a through hole passing through the insulating layer. Through this, the embodiment forms a through electrode that fills a through hole with a large area.

In this case, the embodiment adjusts the current density, which is the plating condition of the plurality of plating processes. Through this, the embodiment forms a first metal layer of a primary plating process and a second metal layer of the secondary plating process constituting each part of a through electrode and a first electrode part. In this case, the first metal layer of the embodiment may be formed with a relatively low current density, and the second metal layer may be formed with a relatively high current density. Accordingly, in the circuit board including a large-area through electrode, the dimple region can be prevented from being included in the through electrode or the first electrode part. Through this, the embodiment can improve product reliability.

In addition, the embodiment allows the upper surface of the first pad to be formed only of the second metal layer through the control of the current density as described above. Accordingly, the embodiment can solve the stain problem due to the upper surface of the first electrode part including both the first and second metal layers, and thereby improve customer satisfaction. In addition, the embodiment can solve the increase in plating time due to the upper surface of the first electrode part including only the first metal layer, thereby improving product yield.

In addition, another embodiment includes a first through electrode and a second electrode part disposed on one side of the first electrode part. In addition, the embodiment includes a second through electrode and a third electrode part disposed on one side of the second electrode part. In this case, the first through electrode or the second electrode part disposed inside includes a dimple region. The second through electrode disposed outside is formed to fill the dimple region of the first through electrode or the second electrode part. Accordingly, in the embodiment, the third electrode part has a thickness thicker than the first electrode part and the second electrode part, and the second electrode part may have a thickness smaller than that of the first electrode part and the third electrode part. Accordingly, the embodiment can simplify the process of forming a through electrode with a large area, thereby improving product yield.

### [Description of Drawings]

FIG. 1 is a view illustrating a circuit board according to a comparative example.
FIG. 2 is a view showing a surface of an electrode part of FIG. 1.
FIG. 3 is a plan view of a circuit board according to a first embodiment.
FIG. 4 (a) is a cross-sectional view of the circuit board of FIG. 3 in a direction A-A'.
FIG. 4 (b) is a cross-sectional view of the circuit board of FIG. 3 in a direction BB'.
FIG. 5 is a detailed configuration diagram of a first electrode part and a through electrode shown in FIG. 3.
FIG. 6 is a view showing an upper surface of the first electrode part of FIG. 5.
FIG. 7 is a first cross-sectional view of a circuit board according to a second embodiment.
FIG. 8 is a second cross-sectional view of a circuit board according to a second embodiment.
FIG. 9 is a view showing a first substrate layer of FIGS. 7 and 8 in detail.
FIGS. 10 to 22 are views for explaining a method of manufacturing a circuit board according to a second embodiment in order of process.
FIG. 23 is a view illustrating a semiconductor package according to an embodiment.

### [Modes of the Invention]

Hereinafter, embodiments disclosed in the present specification will be described in detail with reference to the accompanying drawings, but identical or similar elements are denoted by the same reference numerals regardless of reference numerals, and redundant descriptions thereof will be omitted. The suffixes "module" and "portion" for the components used in the following description are given or used interchangeably in consideration of only the ease of writing the specification, and do not have meanings or roles that are distinguished from each other by themselves. In addition, in describing the embodiments disclosed in the present specification, if it is determined that a detailed description of related known technologies may obscure the subject matter of the embodiments disclosed in the present specification, the detailed description thereof will be omitted. In addition, the accompanying drawings are only for making it easier to understand the embodiments disclosed in the present specification, and the technical idea disclosed in the present specification is not limited by the accompanying drawings, and this should be understood to include all changes, equivalents, or substitutes included in the scope of the present invention.

Terms including ordinal numbers such as first and second may be used to describe various elements, but the elements are not limited by the terms. The above terms are used only for the purpose of distinguishing one component from another component.

When a component is referred to as being "contacted" or "connected" to another component, it may be directly connected or connected to the other component, but other components may exist in the middle. On the other hand, when a component is referred to as being "directly contacted" or "directly connected" to another component, it should be understood that there is no other component in the middle.

Singular expressions include plural expressions unless the context clearly indicates otherwise.

In the present application, terms such as "comprises" or "have" are intended to designate the presence of features, numbers, steps, actions, components, parts, or combinations thereof described in the specification, but one or more other features. It is to be understood that the presence or addition of elements or numbers, steps, actions, components, parts, or combinations thereof, does not preclude in advance the possibility of being excluded.

Hereinafter, embodiments of the present invention will be described in detail with reference to the accompanying drawings.

Before describing the present embodiment, a comparative example compared to the present embodiment will be described.

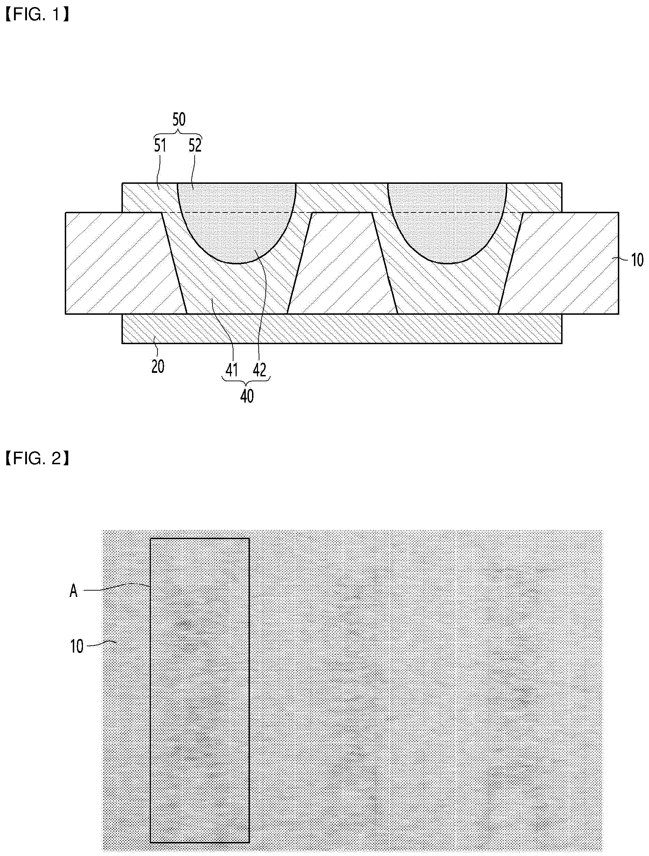

FIG. 1 is a view illustrating a circuit board according to a comparative example, and FIG. 2 is a view showing a surface of an electrode part of FIG. 1.

Referring to FIGS. 1 and 2, a circuit board of the comparative example includes a through electrode having a large area.

Specifically, the circuit board of the comparative example includes an insulating layer 10, a first electrode part 50, a second electrode part 20, and a through electrode 40.

The first electrode part 50 is disposed on an upper surface of the insulating layer 10.

The second electrode part 20 is disposed under a lower surface opposite to the upper surface of the insulating layer 10.

The through electrode 40 is disposed passing through the insulating layer 10. The through electrode 40 passes through the insulating layer 10 and connects the first electrode part 50 and the second electrode part 20.

The through electrode 40 includes a plurality of electrode parts spaced apart from each other in a horizontal direction while being commonly connected to the first electrode part 50 and the second electrode part 20.

Each of the plurality of electrode parts constituting the through electrode 40 is a through electrode having a large area. For example, the circuit board includes a through electrode having a large area. In addition, an area of the large-area through electrode is larger than an area of a normal through electrode. For example, the through electrode 40 includes a plurality of large-area through electrode parts having a width in a first direction(e.g. a longitudinal direction) greater than a width in a second direction(e.g. a width direction).

The through electrode 40 as described above is formed by filling an inside of a through hole with a metal material. In this case, it is difficult to completely fill the inside of the through hole with a through electrode having a large area as described above in one plating process. For example, when the inside of the through hole is filled with only one plating process to form the through electrode with a large area as described above, a dimple phenomenon occurs in a region overlapping the through electrode 40 in a third direction (e.g. a thickness direction) among an entire regions of the first electrode part 50. Here, the dimple phenomenon means a phenomenon in which a central portion of the through electrode 40 or the upper surface of the first electrode part 50 overlapping the through electrode 40 in the third direction is not flat but concave.

Accordingly, in the comparative example, a plurality of plating processes are performed to form the through electrode 40 and the first electrode part 50.

Specifically, the first electrode part 50 and the through electrode 40 are integrally formed. For example, the first electrode part 50 and the through electrode 40 are composed of a first metal layer and a second metal layer formed by performing two plating processes inside the through hole and on an upper surface of the insulating layer 10.

Accordingly, the through electrode 40 includes a first portion 41 of the first metal layer and a first portion 42 of the second metal layer. In addition, the first electrode part 50 includes a second portion 51 of the first metal layer and a second portion 52 of the second metal layer.

That is, when the through electrode 40 and the first electrode part 50 are formed only with the first metal layer, the through hole is not completely filled, and thus the through electrode 40 and accordingly, a dimple phenomenon occurs in the through electrode 40 and the first electrode part 50. Accordingly, in the comparative example, a second metal layer filling a dimple portion is formed by performing secondary plating on the dimple portion of the first metal layer.

In this case, the comparative example simply fills only the dimple portion in a state where a thickness of the second portion 51 of the first metal layer constituting the first electrode part 50 and a thickness of the second portion 52 of the second metal layer are not considered at all.

Accordingly, an upper surface of the first electrode part 50 in the comparative example is made of a plurality of metal layers formed by a plurality of plating processes. Specifically, the upper surface of the first electrode part 50 in the comparative example includes a region made of the second portion 51 of the first metal layer and a region made of the second portion 52 of the second metal layer. In addition, an interface between the second portion 51 of the first metal layer and the second portion 52 of the second metal layer can be visually distinguished.

Specifically, as shown in FIG. 2, the upper surface of the first electrode part 50 has a line (A) dividing the interface between the second portion 51 of the first metal layer and the second portion 52 of the second metal layer, and the line (A) affects the product reliability of the first electrode part (50). For example, the line (A) can be visually confirmed from the outside, and accordingly, it is recognized as a stain, and thus acts as a factor in deteriorating the design of the circuit board.

Therefore, the embodiment includes a through electrode with a large area and removes stains that may form on the surface of the first electrode part of the large-area through electrode while forming the large-area through electrode by performing a plating process a plurality of times.

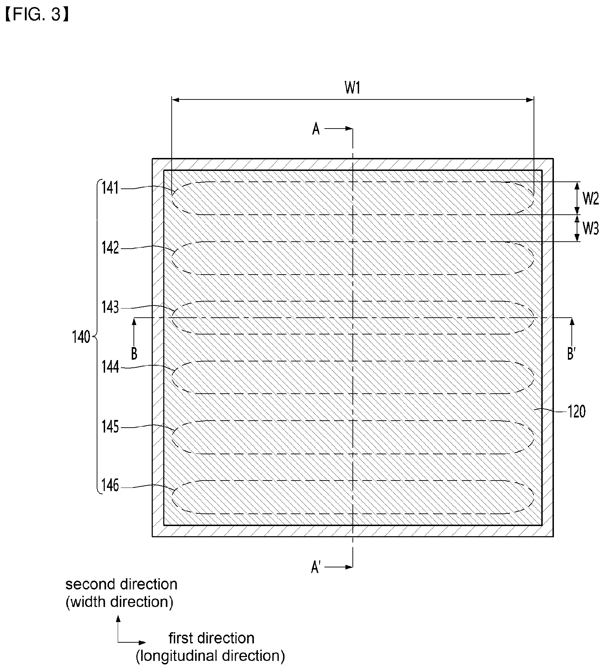

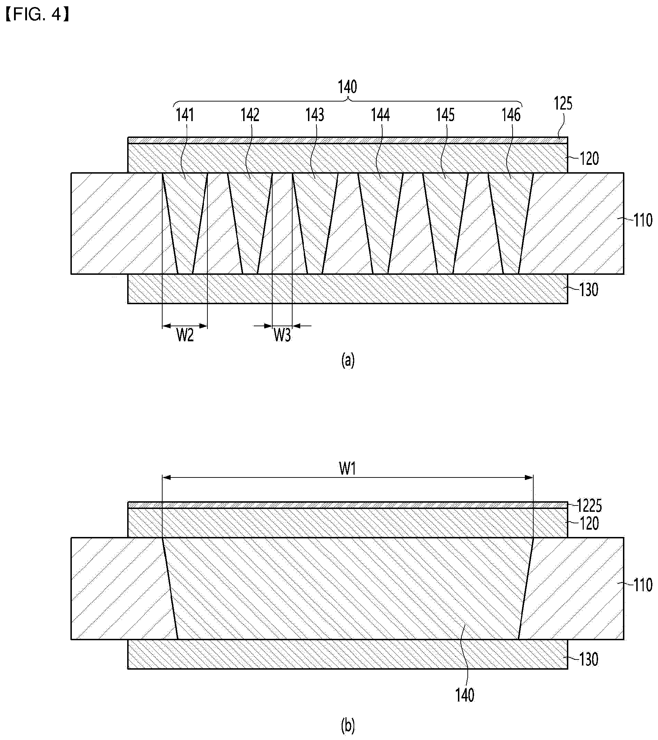

FIG. 3 is a plan view of a circuit board according to a first embodiment, FIG. 4 (a) is a cross-sectional view of the circuit board of FIG. 3 in a direction A-A', and FIG. 4 (b) is a cross-sectional view of the circuit board of FIG. 3 in a direction BB'.

Before explaining this, recently, a size of the through hole has been increased in order to improve the performance of through electrodes for heat dissipation, shielding, and signal transmission, and accordingly, the size of through electrode filling the through hole is also increasing. The embodiment provides a circuit board capable of removing the dimple region of the through electrode or electrode part while removing stains formed on the surface of the electrode part even when the size of the through electrode increases according to this trend.

Referring to FIGS. 3 and 4, the circuit board according to the first embodiment includes an insulating layer 110, a first electrode part 120, a second electrode part 130, a through electrode 140, and a first surface treatment layer 125. The through electrode 140 may also be referred to as a 'via' for electrical connection between layers.

The through electrode 140 may have a large area. For example, the through electrode 140 may be a large-area through electrode having a certain area or more.

For example, the through electrode 140 has a width in a first direction (e.g. a longitudinal direction) greater than a width in a second direction (a width direction). For example, a width of the through electrode 140 in the first direction (e.g. a longitudinal direction) may be twice or more than a width in the second direction (width direction). In addition, the embodiment removes surface stains or dimple regions provided in the through electrode with a large area as described above. Accordingly, hereinafter, the through electrode 140 having a large area and the first electrode part 120 and the second electrode part 130 connected thereto will be mainly described. However, the embodiment is not limited thereto, and the circuit board may include a trace, a through electrode with a normal size, a chip mounting pad, a core pad, and a BGA pad in addition to the first electrode part 120, the second electrode part 130 and the through electrode 140 with a large area.

The insulating layer 110 may have a flat structure. In this case, it is illustrated that the insulating layer 110 has a one-layer structure in the drawing, but the embodiment is not limited thereto. For example, the insulating layer 110 may have a layer structure of two or more layers, and thus the circuit board may be a multi-layer board. However, the embodiment is intended to remove dimple regions or stains provided in through electrodes or electrode parts formed on the outermost insulating layer among the multi-layered insulating layers. Accordingly, the first embodiment will mainly describe an outermost insulating layer of the multilayer insulating layer, and the first electrode part 120, the second electrode part 130, and the through electrode 140 formed on the outermost insulating layer.

The insulating layer 110 is a substrate on which an electric circuit capable of changing wiring is formed and may include all of a printed circuit board, a wiring board, and an insulating board that are made of an insulating material capable of forming circuit patterns on a surface thereof.

For example, the insulating layer 110 may be rigid or flexible. For example, the insulating layer 110 may include glass or plastic. In detail, the insulating layer 110 may include chemically tempered /semi-tempered glass such as soda lime glass or aluminosilicate glass, etc., a tempered or flexible plastic such as polyimide (PI), or polyethylene terephthalate (PET), propylene glycol (PPG), polycarbonate (PC), etc., or sapphire.

In addition, the insulating layer 110 may include an optical isotropic film. As an example, the insulating layer 110 may include cyclic olefin copolymer (COC), cyclic olefin polymer (COP), optical isotropic polycarbonate (PC), optical isotropic polymethyl methacrylate (PMMA), or the like.

In addition, the insulating layer 110 may be formed of a material including an inorganic filler and an insulating resin. For example, the material constituting the insulating layer 110 may include a resin including a reinforcing material such as an inorganic filler such as silica or alumina together with a thermosetting resin such as an epoxy resin or a thermoplastic resin such as polyimide, specifically, ABF (Ajinomoto Build-up Film), FR-4, BT (Bismaleimide Triazine), PID (Photo Imageable Dielectric Resin), BT, etc.

In addition, the insulating layer 110 may be partially bent while having a curved surface. That is, the insulating layer 110 may partially have a plane and may partially be bent while having a curved surface. Specifically, an end portion of the insulating layer 110 may be bent while having a curved surface, or bent or crooked while having a surface with a random curvature.

A circuit pattern layer may be disposed on a surface of the insulating layer 110. The circuit pattern layer may mean an 'electrode part' described below. That is, an 'electrode part' described below may mean a circuit pattern layer, a circuit pattern, a pattern layer, a pad, a trace, etc., but is not limited thereto.

For example, a first electrode part 120 may be disposed on a first surface of the insulating layer 110. In addition, a second electrode part 130 may be disposed on the second surface of the insulating layer 110.

The first electrode part 120 and the second electrode part 130 may be wirings that transmit electrical signals. Alternatively, the first electrode part 120 and the second electrode part 130 may have a heat transfer pattern that transfers heat. To this end, the first electrode part 120 and the second electrode part 130 may be formed of a metal material having high electrical conductivity or high thermal conductivity.

To this end, the first electrode part 120 and the second electrode part 130 may be formed of at least one metal material selected from among gold (Au), silver (Ag), platinum (Pt), titanium (Ti), tin (Sn), copper (Cu), and zinc (Zn). In addition, the first electrode part 120 and the second electrode part 130 may be formed of paste or solder paste including at least one metal material selected from among gold (Au), silver (Ag), platinum (Pt), titanium (Ti), tin (Sn), copper (Cu), and zinc (Zn), which are excellent in bonding force. Preferably, the first electrode part 120 and the second electrode part 130 may be formed of copper (Cu) having high electrical or thermal conductivity and a relatively low cost.

The first electrode part 120 and the second electrode part 130 may be formed by a general process of manufacturing a circuit board, such as an additive process, a subtractive process, a modified semi additive process (MSAP), a semi additive process (SAP), etc., and detailed descriptions thereof will be omitted herein.

A through electrode 140 is formed on the insulating layer 110. That is, the through electrode 140 passes through the upper and lower surfaces of the insulating layer 110.

Accordingly, the through electrode 140 may have a first surface in contact with the lower surface of the first electrode part 120 and a second surface in contact with the upper surface of the second electrode part 130. For example, the through electrode 140 may connect between the first electrode part 120 and the second electrode part 130. For example, the through electrode 140 may electrically connect the first electrode part 120 and the second electrode part 130 to transmit an electrical signal. For example, the through electrode 140 may thermally connect the first electrode part 120 and the second electrode part 130 to form a heat transfer (e.g. heat dissipation) path.

The through electrode 140 may include a plurality of through electrode parts.

For example, the through electrode 140 may include a plurality of first through electrode parts 141, 142, 143, 144, 145, and 146 elongated in a first direction (e.g. a longitudinal direction).

In addition, the plurality of first through electrode parts 141, 142, 143, 144, 145, and 146 of the through electrode 140 may be spaced apart from each other in a second direction (width direction) perpendicular to the first direction (e.g. longitudinal direction).

Each of the first through electrode parts 141, 142, 143, 144, 145, and 146 constituting the through electrode 140 may have a first width W1 in a first direction (e.g. a longitudinal direction). In addition, each of the first through electrode parts 141, 142, 143, 144, 145, and 146 constituting the through electrode 140 may have a second width W2 in a second direction smaller than the first width W1.

The first width W1 may be at least twice as large as the second width W2. For example, the first width W1 may be at least four times greater than the second width W2. For example, the first width W1 may be at least 10 times greater than the second width W2.

The first width W1 may have a range of 100 µm to 3000 µm. For example, the first width W1 may have a range of 300 µm to 2500 µm. For example, the first width W1 may have a range of 800 µm to 2000 µm. When the first width W1 is smaller than 100 µm, the through electrode 140 may be a general through electrode having a normal size rather than a large area through electrode. Specifically, when the first width W1 is smaller than 100 µm, the through electrode 140 may be formed by a single plating process instead of a plurality of plating processes as in the embodiment. When the first width W1 is greater than 3000 µm, the plating time required to form the through electrode 140 may increase rapidly. For example, when the first width W1 is greater than 3000 µm, at least five plating processes must be performed in order to completely remove a dimple region, and accordingly, the time for manufacturing the circuit board increases and the yield may decrease. For example, when the first width W1 is greater than 3000 µm, it may be difficult to completely remove the dimple region of the through electrode 140 even if plating is performed multiple times.

The second width W2 may be determined by processing conditions of through holes constituting each of the first through electrode parts 141, 142, 143, 144, 145, and 146. For example, when the through hole is formed by laser processing, it may be determined by the size of a laser point (not shown). For example, the second width W2 may have a range of 30 µm to 200 µm. For example, the second width W2 may have a range of 40 µm to 150 µm. For example, the second width W2 may have a range of 50 µm to 100 µm. The second width W2 may be equal to the size of the laser point or may be larger than the size of the laser point. For example, when the through hole is processed in one row while moving the laser point in a first direction (e.g. longitudinal direction), the second width W2 may correspond to the size of the laser point. For example, when the through hole is formed by processing a first row and processing a second row at a position overlapping the first row by moving the laser point in the width direction, the second width W2 may be greater than the size of the laser point.

As described above, the first through electrode parts 141, 142, 143, 144, 145, and 146 may be spaced apart from each other by a third width W3 in a second direction (width direction). In this case, the third width W3 may be determined by the size of the laser point. For example, the third width W3 may be smaller than the size of the laser point. For example, the third width W3 may be greater than 1/2 of the size of the laser point. This is to solve a reliability problem in which a plurality of through holes are interconnected due to a laser processing tolerance in the process of forming through holes spaced apart from each other in the second direction (width direction).

Meanwhile, the through electrode 140 as described above may be formed by filling the inside of each of the through holes corresponding to the first through electrode parts 141, 142, 143, 144, 145, and 146 passing through the insulating layer 110 with a conductive material.

The through hole may be formed by any one of mechanical, laser, and chemical processing. When the through hole is formed by mechanical processing, a method such as milling, drilling and routing may be used, when the through hole is formed by laser processing, a method of UV or CO₂ laser may be used, when the through hole is formed by chemical processing, a chemical including amino silane, ketones, or the like may be used.

Meanwhile, the laser processing is a cutting method in which a part of a material is melted and evaporated by concentrating optical energy at a surface to take a desired shape. Complex formation by a computer program may be easily processed, and composite materials which are difficult to cut by other methods may be processed.

When the through hole is formed, the first through electrode parts 141, 142, 143, 144, 145, and 146 may be formed by filling the inside of the through hole with a conductive material. The metal material forming the first through electrode parts 141, 142, 143, 144, 145, and 146 may be any one selected from among copper (Cu), silver (Ag), tin (Sn), gold (Au), nickel (Ni), and palladium (Pd). In addition, the conductive material may be filled by any one of electroless plating, electroplating, screen printing, sputtering, evaporation, ink jetting, and dispensing, or a combination thereof. Preferably, the through electrode 140 including the first through electrode parts 141, 142, 143, 144, 145, and 146 may include the same metal material as the first electrode part 120. For example, the through electrode 140 may have the same layer structure as the first electrode part 120. For example, the through electrode 140 may be integrally formed with the first electrode part 120. For example, the through electrode 140 and the first electrode part 120 may be simultaneously formed by a plating process. Accordingly, the through electrode 140 and the first electrode part 120 may be substantially referred to as one component. For example, a portion formed in a through hole of the insulating layer may be referred to as a through electrode. Also, a portion formed on an upper surface of the insulating layer while being connected to the through electrode may be referred to as a first electrode part.

However, in the embodiment, in the metal layer formed by the plating process, a portion formed in the through hole of the insulating layer 110 is referred to as a through electrode 140, a portion formed on the first surface of the insulating layer 110 and the first surface of the through electrode 140 is referred to as a first electrode part 120.

The first electrode part 120 and the through electrode 140 may be formed by a plurality of plating processes. Specifically, the first electrode part 120 and the through electrode 140 may be formed by forming metal layers by two plating processes. Accordingly, each of the first electrode part 120 and the through electrode 140 may be composed of a plurality of metal layers formed by a plurality of plating processes. However, the embodiment is not limited thereto. For example, the plating process may be performed three or more times, and accordingly, the first electrode part 120 and the through electrode 140 may include three or more metal layers. However, when plating is performed three or more times in forming the first electrode part 120 and the through electrode 140, there is a problem of decreasing process yield due to increased plating time. The embodiment allows the optimal first electrode part 120 and through electrode 140 to be formed by two plating processes.

In addition, the embodiment allows the upper surface of the first electrode part 120 to consist of only one of the plurality of metal layers by multiple plating processes even when the first electrode part 120 is formed by multiple plating processes. This can be achieved by adjusting a plating condition of the plurality of plating processes. In this case, the plating condition may be the plating current density of the plating process. That is, when plating is performed twice to form the through electrode 140 and the first electrode part 120, the embodiment allows the plating current density in a primary plating process to be different from the plating current density in a secondary plating process. In addition, the embodiment allows stains on the surface of the first electrode part 120 to be removed through changes in the plating current density.

Preferably, the embodiment allows the current density of the primary plating process to be smaller than the current density of the secondary plating process. Accordingly, the embodiment allows the upper surface of the second electrode part 130 to be formed as a metal layer formed by a secondary plating process with a relatively high current density.

For example, in the comparative example, the current density of the primary plating process and the current density of the secondary plating process were substantially the same. Accordingly, in the comparative example, the upper surface of the first electrode part includes both the metal layer of the primary plating process and the metal layer of the secondary plating process, and this causes staining.

Also, unlike the embodiment, the current density of the primary plating process may be relatively increased and the current density of the secondary plating process may be relatively decreased. And in this case, the upper surface of the first electrode part may be composed of only the metal layer of the primary plating process. However, in this case, a dimple region may be substantially filled with the primary plating process. In addition, there is a problem in that considerable plating time is required to completely fill a through hole having a large area without a dimple region in the primary plating process.

Therefore, the embodiment reduces the current density for the primary plating process and increases the current density for the secondary plating process compared to the comparative example, thereby reducing the plating time while removing the stain.

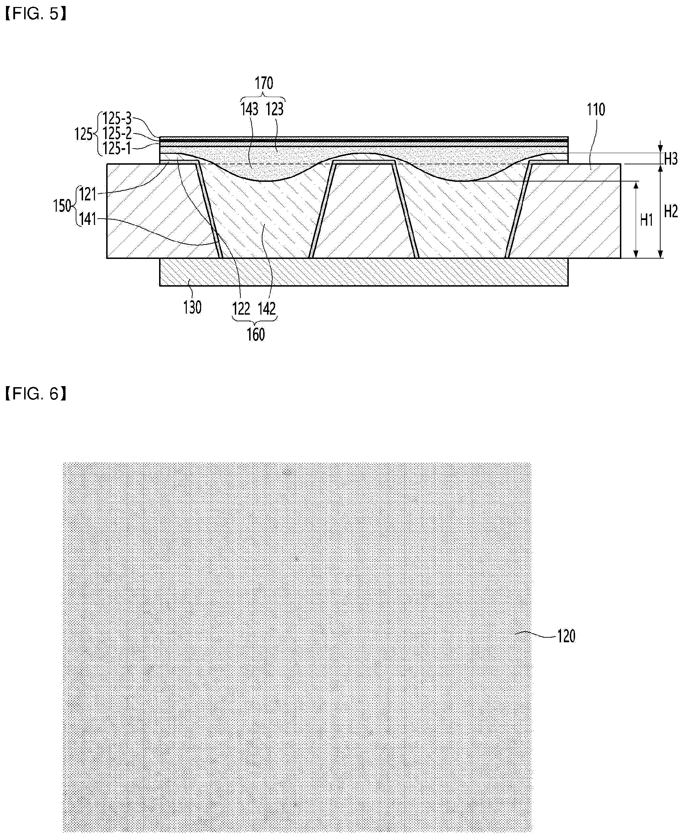

FIG. 5 is a detailed configuration diagram of a first electrode part and a through electrode shown in FIG. 3, and FIG. 6 is a view showing an upper surface of the first electrode part of FIG. 5.

Referring to FIGS. 5 and 6, the first electrode part 120 and the through electrode 140 are formed by a plurality of plating processes. For example, the first electrode part 120 and the through electrode 140 include a seed layer 150, a first metal layer 160 and a second metal layer 170.

The seed layer 150 may be a seed layer for forming the first metal layer 160 and the second metal layer 170 by electrolytic plating. The seed layer 150 may be formed on a first surface of the insulating layer 110 and an inner wall of a through hole formed in the insulating layer 110.

That is, the seed layer 150 may include a first portion 141 formed on an inner wall of the through hole and a second portion 121 formed on a first surface of the insulating layer 110. Also, the first portion 141 of the seed layer 150 may constitute a through electrode 140. In addition, the second portion 121 of the seed layer 150 may constitute the first electrode part 120.

The first metal layer 160 may be formed by performing primary electrolytic plating using the seed layer 150.

The first metal layer 160 may include a first portion 142 formed on the first portion 141 of the seed layer 150 and a second portion 122 formed on the second portion 121 of the seed layer 150.

The first portion 142 of the first metal layer 160 may constitute the through electrode 140. Also, the second portion 122 of the first metal layer 160 may constitute the first electrode part 120. For example, the first portion 142 of the first metal layer 160 may partially fill the through hole. Also, the second portion 122 of the first metal layer 160 may be formed to have a certain height on the second portion 121 of the seed layer 150.

The first portion 142 of the first metal layer 160 may include a concave portion (e.g. a concave portion). For example, an upper surface of the first portion 142 of the first metal layer 160 may have a curved surface concaved in a downward direction. In this case, a lowermost end of the upper surface of the first portion 142 of the first metal layer 160 may be positioned lower than the first surface or the upper surface of the insulating layer 110. For example, the through hole formed in the insulating layer 110 is not completely filled by the first portion 142 of the first metal layer 160. For example, at least a portion (e.g. the concave portion) of the through hole may not be filled (or not be buried) by the first portion 142 of the first metal layer 160. This can be achieved by reducing the current density compared to the comparative example in a condition for plating the first metal layer 160.

Meanwhile, an upper surface of the second portion 122 of the first metal layer 160 may have a curved surface. For example, the upper surface of the second portion 122 of the first metal layer 160 may gradually increase in height as a distance from a central portion of the through electrode 140 increases. For example, the upper surface of the second portion 122 of the first metal layer 160 may have a highest height at a position furthest from a center of the through electrode 140.

The second metal layer 170 may be formed on the first metal layer 160 by electroplating using the seed layer 150.

The second metal layer 170 may include a first portion 143 formed on the first portion 142 of the first metal layer 160 and a second portion 123 formed on the second portion 122 of the first metal layer 160.

The first portion 143 of the second metal layer 170 may fill (or bury) the concave portion (or concave portion) of the first portion 142 of the first metal layer 160. For example, a lower surface of the first portion 143 of the second metal layer 170 may include a convex portion. For example, the lower surface of the first portion 143 of the second metal layer 170 may have a downwardly convex curved surface. In this case, a lowermost end of the lower surface of the first portion 143 of the second metal layer 170 may be positioned lower than the first surface of the insulating layer 110. This can be achieved by increasing the current density compared to the comparative example in a condition for plating the second metal layer 170.

Meanwhile, an upper surface of the second portion 123 of the second metal layer 170 may have a flat surface. For example, the lower surface of the second portion 123 of the second metal layer 170 may have a curved surface. Preferably, the second portion 123 of the second metal layer 170 may have different thicknesses for each region. For example, a thickness of a first region overlapping the through electrode 140 in the third direction (or vertical direction) of the second portion 123 may be greater than a thickness of a second region other than the first region.

As described above, the through electrode 140 and the first electrode part 120 are composed of the seed layer 150, the first metal layer 160, and the second metal layer 170.

For example, the through electrode 140 may include the first portion 141 of the seed layer 150, the first portion 142 of the first metal layer 160, and the first portion 143 of the second metal layer 170.

For example, the first electrode part 120 may include the second portion 121 of the seed layer 150, the second portion 122 of the first metal layer 160, and the second portion 123 of the second metal layer 170. In this case, the first electrode part 120 may have different layer structures for each region. For example, the first electrode part 120 may include a first region overlapping the through electrode 140 in a third direction (e.g. a vertical direction or a thickness direction), and a second region other than the first region. Also, the first region of the first electrode part 120 may include only the first portion 143 of the second metal layer 170. In addition, the second region of the first electrode part 120 may include the second portion 121 of the seed layer 150, the second portion 122 of the first metal layer 160, and the second portion 123 of the second metal layer 170. For example, the first region of the first electrode part 120 may have a one-layer structure, and the second region of the first electrode part 120 may have a three-layer structure.

Meanwhile, as described above, the first portion 142 of the first metal layer 160 may have different thicknesses for each region. For example, the first portion 142 of the first metal layer 160 may have a greatest thickness in an edge region of the through hole and a smallest thickness in a central region of the through hole.

In this case, the embodiment may adjust a position of a lowermost end of the upper surface of the first portion 142 of the first metal layer 160 by adjusting the current density of the primary plating process as described above. That is, a first thickness H1 may be provided between the lower surface of the first portion 142 of the first metal layer 160 and a lowermost end of the upper surface of the first portion 142 of the first metal layer 160. In addition, the embodiment can adjust the current density so that the first thickness H1 can be controlled, and accordingly, it is possible to remove the stain. The first thickness H1 may have a range of 30% to 95% of the width W2 of the through electrode 140 in the second direction. For example, the first thickness H1 may have a range of 35% to 90% of the width W2 of the through electrode 140 in the second direction. For example, the first thickness H1 may have a range of 40% to 85% of the width W2 of the through electrode 140 in the second direction. When the first thickness H1 is less than 35% of the width W2 of the through electrode 140 in the second direction, the time of the secondary plating process for forming the second metal layer 170 may increase. In addition, when the first thickness H1 is smaller than 35% of the width W2 of the through electrode 140 in the second direction, it may be difficult to completely fill the dimple region with only the second metal layer 170. When the first thickness H1 is greater than 95% of the width W2 of the through electrode 140 in the second direction, the time required to form the first metal layer 160 by the primary plating process increases, and thus yield may decrease. In addition, when the first thickness H1 is greater than 95% of the width W2 in the second direction, a portion of the first electrode part 120 may be composed of only the second portion 122 of the first metal layer 160, and this may cause stains.

Meanwhile, a thickness H2 of the through electrode 140 may correspond to a thickness of the insulating layer 110. A thickness H2 of the through electrode 140 may have a range of 10 µm to 200 µm. For example, the thickness H2 of the through electrode 140 may have a range of 15 µm to 150 µm. For example, the thickness H2 of the through electrode 140 may have a range of 20 µm to 120 µm.

In addition, the embodiment may adjust the height of an uppermost end of the second portion 122 of the first metal layer 160 of the first electrode part 120 by controlling the current density of the primary plating process as described above. A height H3 of the uppermost end of the second portion 122 of the first metal layer 160 may refer to a thickness H3 from the lower surface of the second portion 121 of the seed layer 150 to the uppermost end of the second portion 122 of the first metal layer 160. Also, the height H3 of the uppermost end of the second portion 122 of the first metal layer 160 may be determined by the thickness of the first electrode part 120. The thickness of the first electrode part 120 may mean a distance or height between the first surface of the insulating layer 110 and the upper surface of the second portion 123 of the second metal layer 170. For example, the height H3 of the uppermost end of the second portion 122 of the first metal layer 160 may satisfy a range of 50% to 85% of a thickness of the first electrode part 120. For example, the height H3 of the uppermost end of the second portion 122 of the first metal layer 160 may satisfy a range of 52% to 80% of the thickness of the first electrode part 120. For example, the height H3 of the uppermost end of the second portion 122 of the first metal layer 160 may satisfy a range of 55% to 78% of the thickness of the first electrode part 120. When the height H3 of the uppermost end of the second portion 122 of the first metal layer 160 is less than 50% of the thickness of the first electrode part 120, an area of the dimple region of the through electrode 140 increases, and thus the dimple region may not be completely filled by the second metal layer. In addition, when the height H3 of the uppermost end of the second portion 122 of the first metal layer 160 is greater than 85% of the thickness of the first electrode part 120, a stain may occur on the upper surface of the first electrode part 120.

As described above, the embodiment allows to form the first metal layer 160 and the second metal layer 170 corresponding to the through electrode 140 and the first electrode part 120 by performing primary plating and secondary plating. In addition, the dimple region that may be included in the through electrode 140 may be completely removed by adjusting plating conditions of the first metal layer 160. Furthermore, the stain that may be formed on the surface of the first electrode part 120 can be removed.

On the other hand, the first electrode part 120 of the embodiment includes a first surface treatment layer 125.

The first surface treatment layer 125 may be formed on the second portion 123 of the second metal layer 170 of the first electrode part 120. In this case, the first surface treatment layer 125 may be formed only on the upper surface of the first electrode part 120. Alternatively, the first surface treatment layer 125 may be formed not only on the upper surface of the first electrode part 120 but also on the side surface.

The first surface treatment layer 125 may include a first-first surface treatment layer 125-1, a first-second surface treatment layer 125-2, and a first-third surface treatment layer 125-3.

The first-first surface treatment layer 125-1 may be formed on the first electrode part 120. The first-second surface treatment layer 125-2 may be formed on the first-first surface treatment layer 125-1. In addition, the first-third surface treatment layer 125-3 may be formed on the first-second surface treatment layer 125-2.

The first-first surface treatment layer 125-1 may include nickel (Ni). Accordingly, the first-first surface treatment layer 125-1 may be referred to as a nickel metal layer. The first-first surface treatment layer 125-1 may include only nickel or may be formed of an alloy including nickel and P (phosphorus), B (boron), W (tungsten), or Co (cobalt).

The first-first surface treatment layer 125-1 may have a thickness of 2 µm to 10 µm. For example, the first-first surface treatment layer 125-1 may have a thickness of 3 µm to 8 µm. For example, the first-first surface treatment layer 125-1 may have a thickness of 4 µm to 6 µm.

The first-second surface treatment layer 125-2 may include palladium (Pd). Accordingly, the first-second surface treatment layer 125-2 may be referred to as a palladium metal layer. The first-second surface treatment layer 125-2 may include only palladium, or may further include at least one metal selected from cobalt (Co), zinc (Zn), nickel (Ni), and an inorganic material in addition to palladium. The first-second surface treatment layer 125-2 may have a thickness of 0.001 µm to 0.5 µm. For example, the first-second surface treatment layer 125-2 may have a thickness of 0.005 µm to 0.2 µm. For example, the first-second surface treatment layer 125-2 may have a thickness of 0.01 µm to 0.1 µm.

The first-third surface treatment layer 125-3 may include gold (Au). The first-third surface treatment layer 125-3 may have a thickness of 0.001 µm to 0.5 µm. For example, the first-third surface treatment layer 125-3 may have a thickness of 0.005 µm to 0.2 µm. For example, the first-third surface treatment layer 125-3 may have a thickness of 0.01 µm to 0.1 µm.

As described above, the embodiment proceeds with a plurality of plating processes to form a through electrode of a circuit board that fills a through hole with a large area. In this case, the embodiment adjusts the current density, which is the plating condition of the plurality of plating processes to form a first metal layer of a primary plating process and a second metal layer of the secondary plating process constituting a through electrode and a first electrode part. In this case, the first metal layer of the embodiment may be formed with a relatively low current density, and the second metal layer may be formed with a relatively high current density. Accordingly, in the circuit board including a large-area through electrode, the dimple region can be prevented from being included in the through electrode or the first electrode part. Through this, the embodiment can improve product reliability. In addition, the embodiment allows the upper surface of the first pad to be formed only of the second metal layer through the control of the current density as described above. Accordingly, the embodiment can solve the stain problem due to the upper surface of the first electrode part including both the first and second metal layers, and thereby improve customer satisfaction. In addition, the embodiment can solve the increase in plating time due to the upper surface of the first electrode part including only the first metal layer, thereby improving product yield.

On the other hand, the circuit board of the embodiment may have a plurality of layer structure. For example, the circuit board of the embodiment may be a multilayer circuit board. Hereinafter, a multilayer structure of the circuit board according to the embodiment will be described.

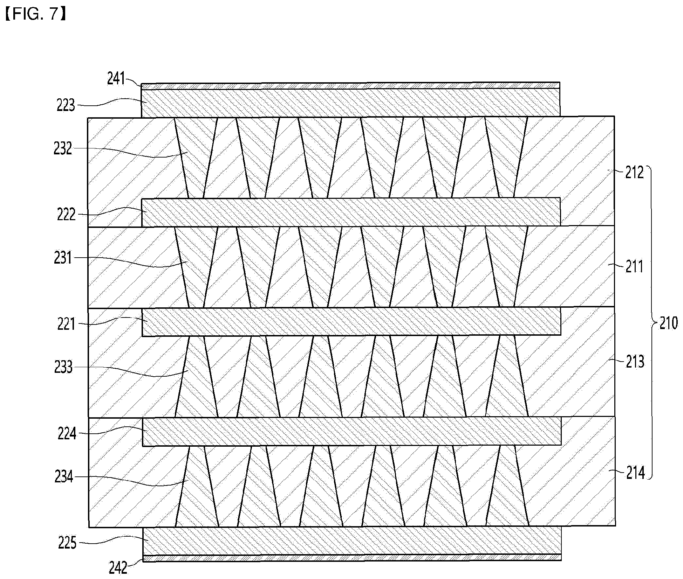

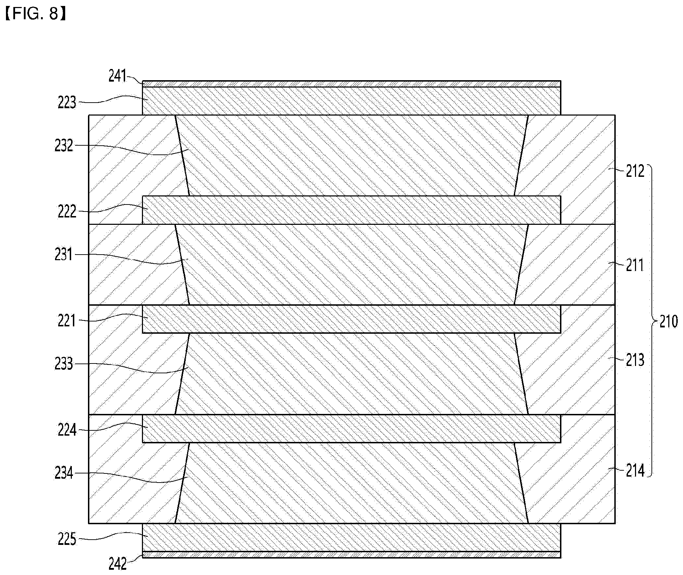

FIG. 7 is a first cross-sectional view of a circuit board according to a second embodiment, and FIG. 8 is a second cross-sectional view of a circuit board according to a second embodiment.

For example, FIG. 7 may be a cross-sectional view of FIG. 3 in a direction A-A', and FIG. 8 may be a cross-sectional view of FIG. 3 in a direction B-B'.

Referring to FIGS. 7 and 8, the circuit board includes a plurality of insulating layers, a plurality of electrode parts, and a plurality of through electrodes.

For example, the insulating layer 210 may include first to fourth insulating layers 211, 212, 213, and 214. Specifically, the insulating layer 110 may include a first insulating layer 211 disposed on a first surface of a first electrode part 221, a second insulating layer 212 disposed on a first surface of the first insulating layer 211, a third insulating layer 213 disposed on a second surface of the first electrode part 221 or a second surface of the first insulating layer 211, and a fourth insulating layer 214 disposed on the second surface of the third insulating layer 213.

In this case, in the embodiment, it is illustrated that the insulating layer 210 has a 4-layer structure, but the embodiment is not limited thereto. For example, the insulating layer 210 may have more layers than the fourth layer.

However, the first electrode part 221 of the embodiment is disposed on a reference insulating layer as a reference in a stacking structure of the insulating layer 210. Here, the reference insulating layer may mean an insulating layer initially stacked in a process of manufacturing a circuit board. For example, the first insulating layer 211 may be a layer that is first stacked in the circuit board of the embodiment, and accordingly, the first insulating layer 211 may serve as a reference insulating layer.

The first electrode part 221 may be a reference electrode part or a reference electrode part. For example, the first electrode part 221 may be a reference electrode part or a reference electrode part disposed on the second surface of the reference insulating layer. Here, the reference electrode part may refer to an electrode part disposed at a center in the stacked structure of the circuit board. Specifically, the process of the manufacturing the circuit board proceeds with a first process of forming an insulating layer, an electrode part, and a through electrode on one side of the reference electrode part based on the reference electrode part, and a second process of forming an insulating layer, an electrode part, and a through electrode on the other side of the reference electrode part. In addition, the reference electrode part may be a pad or electrode part that is a reference for performing the first process and the second process. In this case, according to an embodiment, the number of insulating layers disposed on one side of the reference electrode part may be the same as the number of insulating layers disposed on the other side of the reference electrode part. Also, the reference electrode part may be disposed at the center of the stacked structure in the thickness direction of the circuit board. However, the embodiment is not limited thereto, the number of insulating layers disposed on one side of the reference electrode part and the number of insulating layers disposed on the other side of the reference electrode part may be different from each other. And, in this case, the reference electrode part may be disposed biased to one side or the other side from the center of the circuit board. However, hereinafter, it will be described assuming that the first electrode part 221, which is the reference electrode part, is disposed in the center of the circuit board.

An embodiment may include a first substrate layer disposed on one side of the first electrode part 221 and a second substrate layer disposed on the other side of the first electrode part 221. For example, the first substrate layer may include a first insulating layer 211, a second insulating layer 212, a first through electrode 231, a second electrode part 222, and a second through electrode 232, a third electrode part 223, and a first surface treatment layer 241. For example, the second substrate layer may include a third insulating layer 213, a fourth electrode part 224, a third through electrode 233, a fourth through electrode 234, and a fifth electrode part 225, and a second surface treatment layer 242.

In this case, the first substrate layer may have a symmetrical structure with the second substrate layer based on the first electrode part 221. However, the embodiment is not limited thereto, and the first substrate layer and the second substrate layer may have different numbers of insulating layers, and thus may have an asymmetric structure. However, hereinafter, the first substrate layer and the second substrate layer will be described as having a mutually symmetrical structure based on the first electrode part 221. In this case, the first substrate layer and the second substrate layer have substantially the same layer structure, and accordingly, the first substrate layer will be mainly described.

The first electrode part 221 is disposed on a second surface of the first insulating layer 211. The first electrode part 221 may have a first thickness H4. The first electrode part 221 may have a cross-sectional shape or layer structure different from a cross-sectional shape or layer structure of the second electrode part 222 and the third electrode part 223 described below. For example, the first electrode part 221 may have a cross-sectional shape different from a cross-sectional shape of the second electrode part 222 and the third electrode part 223. For example, the first electrode part 221 may have a square shape. For example, the first electrode part 221 may have a layer structure different from a layer structure of the third electrode part 223. For example, the number of layer of the first electrode part 221 may be smaller than the number of layers of the third electrode part 223.

The first through electrode 231 passes through the first insulating layer 211. The first through electrode 231 may be a through electrode having a large area. For example, the first through electrode 231 may include a plurality of first through electrode parts having a bar shape elongated in a first direction (e.g. a longitudinal direction). The plurality of first through electrode parts may be spaced apart from each other in a second direction (width direction) within the first insulating layer 211. A plurality of first through electrode parts constituting the first through electrode 231 may be connected to the first electrode part 221 and the second electrode part 222. For example, lower surfaces of a plurality of first through electrode parts constituting the first through electrode 231 may be connected in common to the first electrode part 221, and upper surfaces of the plurality of first through electrode parts may be connected in common to a second electrode part 222 to be described later.

The second electrode part 222 may be disposed on a first surface of the first insulating layer 211. The second electrode part 222 may also be referred to as an inner electrode part. For example, the second electrode part 222 may be disposed between a reference electrode part and an outermost electrode part. The second electrode part 222 may have a cross-sectional shape different from a cross-sectional shape of the first electrode part 221. For example, the upper surface of the second electrode part 222 may have a curved surface. For example, the second electrode part 222 may include a concave portion that is concave in a direction toward the first electrode part 221. For example, the second electrode part 222 may include a dimple region. The second electrode part 222 may have a second thickness H2. In this case, the second thickness H2 of the second electrode part 222 may mean a thickness of a portion having a greatest thickness in the second electrode part 222. For example, the second electrode part 222 includes the concave portion as described above, and thus may have different thicknesses for each region. Accordingly, the second thickness H2 of the second electrode part 222 may mean a straight line distance from a lowermost end to an uppermost end of the second electrode part 222. The second thickness H2 of the second electrode part 222 may be smaller than the first thickness H1 of the first electrode part 221. This will be described in detail below.

A second insulating layer 212 is disposed on the second electrode part 222 and the first insulating layer 211.

The second through electrode 232 may be disposed passing through the second insulating layer 212.

The second through electrode 232 is a through electrode with a large area. For example, the second through electrode 232 may include a plurality of second through electrode parts having a bar shape elongated in a first direction (e.g. a longitudinal direction). The plurality of second through electrode parts may be spaced apart from each other in a second direction (width direction) within the second insulating layer 212. A plurality of second through electrode parts constituting the second through electrode 232 may be connected to the second electrode part 222 and the third electrode part 223. For example, lower surfaces of a plurality of second through electrode parts constituting the second through electrode 232 may be connected in common to the second electrode part 222, and upper surfaces of the plurality of second through electrode parts may be connected in common to a third electrode part 223 to be described later.

A third electrode part 223 is disposed on the first surface of the second insulating layer 212. The third electrode part 223 may be an outermost electrode part. The third electrode part 223 may have a layer structure different from a layer structure of the first electrode part 221 and the second electrode part 222. For example, the number of layers of the third electrode part 223 may be greater than the number of layers of the first electrode part 221 or the number of layers of the second electrode part 222.

That is, the embodiment allows only one plating process to be performed to form a through electrode disposed inside the circuit board, and accordingly, a dimple region is provided in the through electrode disposed inside. In addition, the embodiment allows a plurality of plating processes to be performed to form a through electrode disposed on the outermost side of the circuit board. Through this, the embodiment allows the dimple region of an inner through electrode to be entirely filled in a process of plating an outermost through electrode. Accordingly, the third electrode part 223 disposed on the outermost side may have a greater number of layers than each of the first electrode part 221 and the second electrode part 222. A cross section of the third electrode part 223 may have a square shape. For example, an upper surface of the third electrode part 223 may be flat. For example, a cross-sectional shape of the third electrode part 223 may correspond to a cross-sectional shape of the first electrode part 221. For example, the cross-sectional shape of the third electrode part 223 may be different from the cross-sectional shape of the second electrode part 222.

The third electrode part 223 may have a third thickness H3. For example, the third electrode part 223 may have a third thickness H3 greater than the first thickness H1 of the first electrode part 221 and the second thickness H2 of the second electrode part 222.

In the above embodiment, a plurality of electrode parts arranged on one side of the first electrode part 221, which is a reference electrode part, may have different thicknesses. In addition, the embodiment allows the inner electrode part disposed on one side of the first electrode part 221, which is the reference electrode part, to include a dimple region, and the dimple region of the inner electrode part can be filled by another through electrode disposed on one side of the first electrode part, which is the reference electrode part. Hereinafter, this structure will be described in detail.

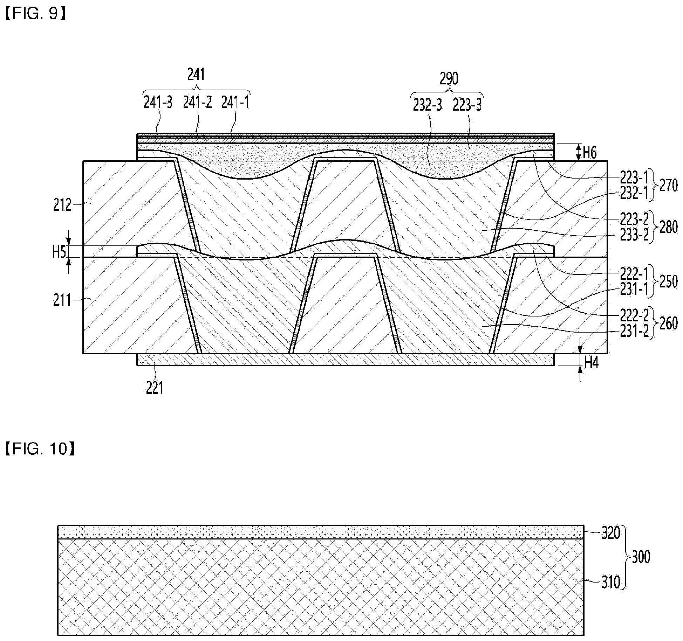

FIG. 9 is a view showing the first substrate layer of FIGS. 7 and 8 in detail.

Referring to FIG. 9, the circuit board includes a first electrode part 221, a first insulating layer 211, a first through electrode 231, a second electrode part 222, a second insulating layer 212, a second through electrode 232 and a third electrode part 223.

The first electrode part 221 may have a first thickness H4. For example, the first thickness H4 of the first electrode part 221 may satisfy a range of 12 µm to 22 µm. For example, the first thickness H4 of the first electrode part 221 may satisfy a range of 14 µm to 20 µm. For example, the first thickness H4 of the first electrode part 221 may satisfy a range of 15 µm to 19 µm. The first electrode part 221 may have a one-layer structure, or may have a two-layer structure. For example, the first electrode part 221 may be formed by etching a copper foil layer having a thickness corresponding to the first thickness H4. Accordingly, the first electrode part 221 may have a one-layer structure corresponding to the copper foil layer. Alternatively, the first electrode part 221 may include a seed layer and a metal layer electroplated using the seed layer. In this case, the first thickness H4 of the first electrode part 221 may be the sum of the thickness of the seed layer and the thickness of the metal layer.

A second electrode part 222 is disposed on a first surface of the first insulating layer 211. The second electrode part 222 may be connected to a first through electrode 231 passing through the first insulating layer 211. Preferably, the layer structure of the second electrode part 222 may be the same as the layer structure of the first through electrode 231. For example, the second electrode part 222 may be integrally formed with the first through electrode 231. For example, the first through electrode 231 and the second electrode part 222 may be simultaneously formed by a process of plating. Accordingly, the first through electrode 231 and the second electrode part 222 may be substantially referred to as one component. However, in the embodiment, a portion formed in a first through hole is referred to as the first through electrode 231, and a portion disposed on the first surface of the first insulating layer 211 is referred to as a second electrode part 222.

The second electrode part 222 and the first through electrode 231 may include a first seed layer 250 and a first metal layer 260.

The first seed layer 250 may be a seed layer for forming the first metal layer 260 by electrolytic plating. The first seed layer 250 may be formed on a first surface of the first insulating layer 211 and an inner wall of the first through hole. That is, the first seed layer 250 may include a first portion 231-1 formed on the inner wall of the first through hole and a second portion 222-1 formed on the first surface of the first insulating layer 211. Also, the first portion 231-1 of the first seed layer 250 may constitute the first through electrode 231. Also, the second portion 222-1 of the first seed layer 250 may constitute the second electrode part 222.

The first metal layer 260 may be formed by electrolytic plating using the first seed layer 250. The first metal layer 260 may include a first portion 231-2 formed on the first portion 231-1 of the first seed layer 250 and a second portion 222-2 formed on the second portion 222-1 of the first seed layer 250.

The first portion 231-2 of the first metal layer 260 may constitute the first through electrode 231, and the second portion 222-2 of the first metal layer 260 may constitute the second electrode part 222.

Specifically, the first through electrode 231 includes a first portion 231-1 of the first seed layer 250 and a first portion 231-2 of the first metal layer 260. In addition, the second electrode part 222 includes a second portion 222-1 of the first seed layer 250 and a second portion 222-2 of the first metal layer 260.

In this case, the first through hole formed in the first insulating layer 211, specifically, the first through hole constituting the first through electrode 231 is a through hole having a large area. Therefore, it may be difficult to entirely fill the first through hole with only the first metal layer 260. Accordingly, the first metal layer 260 may include a dimple region. For example, the second portion 222-2 of the first metal layer 260 may include a concave portion. For example, an upper surface of the second portion 222-2 of the first metal layer 260 may include a curved surface. An upper surface of the second portion 222-2 of the first metal layer 260 corresponds to an upper surface of the second electrode part 222. Accordingly, the upper surface of the second electrode part 222 may include a concave portion or a curved surface. For example, the second electrode part 222 may include a dimple region. At this time, when the dimple region is included in the second electrode part 222, a process of stacking the next layer generally proceeds after filling the dimple region. However, in this case, the number of plating processes for each layer increases, and thus the yield may decrease. Accordingly, the embodiment allows the dimple region to be included in the inner through electrode and the inner electrode part. The embodiment allows removal or filling of the dimple region of the outermost through electrode and the outermost electrode part while filling the dimple region of the inner through electrode and the inner electrode part by the outermost through electrode and the outermost electrode part formed by a plurality of plating processes.

The second electrode part 222 may have a second thickness H5. For example, the second thickness H5 of the second electrode part 222 may be smaller than the first thickness H4 of the first electrode part 221. The second thickness H5 of the second electrode part 222 may mean the thickness of the second portion 222-1 of the first seed layer 250 and the second portion 222-2 of the first metal layer 260. The second thickness H5 of the second electrode part 222 may satisfy a range of 8 µm to 18 µm. For example, the second thickness H5 of the second electrode part 222 may satisfy a range of 10 µm to 16 µm. For example, the second thickness H5 of the second electrode part 222 may satisfy a range of 9 µm to 15 µm. When the second thickness H5 of the second electrode part 222 is less than 8 µm, a size of the dimple region of the second electrode part 222 increases, and accordingly, a problem may occur in reliability of the second through electrode 232 later. For example, the dimple region of the second electrode part 222 may be filled by the second through electrode 232. In this case, as the size of the dimple region of the second electrode part 222 increases, the size of the dimple region formed in the second through electrode 232 also increases. Accordingly, a dimple region may be included in the second through electrode 232 and the third electrode part 223 or a plating process for removing the dimple region may be complicated.

The third electrode part 223 and the second through electrode 232 are formed by a plurality of plating processes. For example, the third electrode part 223 and the second through electrode 232 include a second seed layer 270, a second metal layer 280 and a third metal layer 290.

The second seed layer 270 may be a seed layer for forming the second metal layer 280 and the third metal layer 290 by electrolytic plating. The second seed layer 270 may be formed on a first surface of the second insulating layer 212 and an inner wall of a second through hole formed in the second insulating layer 212.

That is, the second seed layer 270 may include a first portion 232-1 formed on the inner wall of the second through hole and a second portion 223-1 formed on the first surface of the second insulating layer 212. Also, the first portion 232-1 of the second seed layer 270 may constitute a second through electrode 232. Also, the second portion 223-1 of the second seed layer 270 may constitute the third electrode part 223.

The second metal layer 280 may be formed by performing primary electroplating using the second seed layer 270.

The second metal layer 280 may include a first portion 232-2 formed on the first portion 232-1 of the second seed layer 270 and a second portion 223-2 formed on the second portion 223-1 of the second seed layer 270.

The first portion 232-2 of the second metal layer 280 may constitute the second through electrode 232. Also, the second portion 223-2 of the second metal layer 280 may constitute the third electrode part 223. For example, the first portion 232-2 of the second metal layer 280 may partially fill the second through hole. Also, the second portion 223-2 of the second metal layer 280 may be formed to have a predetermined height above the second portion 223-1 of the second seed layer 270.

The first portion 232-2 of the second metal layer 280 may include a concave portion. For example, an upper surface of the first portion 232-2 of the second metal layer 280 may have a curved surface concaved in a downward direction. In this case, a lowermost end of the upper surface of the first portion 232-2 of the second metal layer 280 may be positioned lower than the first surface of the second insulating layer 212. For example, the second through hole formed in the second insulating layer 212 is not completely filled by the first portion 232-2 of the second metal layer 280. For example, at least a portion (e.g. the concave portion) of the second through hole may not be filled by the first portion 232-2 of the second metal layer 280.

The first portion 232-2 of the second metal layer 280 may include a convex portion. For example, a lower surface of the first portion 232-2 of the second metal layer 280 may have a convex curved surface in a downward direction. For example, the first portion 232-2 of the second metal layer 280 may include an upper surface corresponding to a concave portion of the upper surface of the first electrode part 221. A lowermost end of the first portion 232-2 of the second metal layer 280 (lowermost end of the second through electrode 232 ) may be positioned lower than an uppermost end of the first electrode part 221.

Meanwhile, an upper surface of the second portion 223-2 of the second metal layer 280 may have a curved surface. For example, the upper surface of the second portion 223-2 of the second metal layer 280 may gradually increase in height as a distance from a central portion of the second through electrode 232 increases. For example, the upper surface of the second portion 223-2 of the second metal layer 280 may have a greatest height at a position furthest from the center of the second through electrode 232.

The third metal layer 290 may be formed on the second metal layer 280 by electroplating the second seed layer 270.

The third metal layer 290 may include a first portion 232-3 formed on the first portion 232-2 of the second metal layer 280 and a second portion 223-3 formed on the second portion 223-2 of the second metal layer 280.

The first portion 232-3 of the third metal layer 290 may fill the concave portion of the first portion 232-2 of the second metal layer 280. For example, a lower surface of the first portion 232-3 of the third metal layer 290 may include a convex portion. For example, the lower surface of the first portion 232-3 of the third metal layer 290 may have a convex curved surface in a downward direction. In this case, a lowermost end of the lower surface of the first portion 232-3 of the third metal layer 290 may be positioned lower than the first surface of the second insulating layer 212.

Meanwhile, an upper surface of the second portion 223-3 of the third metal layer 290 may have a flat surface. For example, a lower surface of the second portion 223-3 of the third metal layer 290 may have a curved surface in a specific region and may have a curved surface in another specific region. Preferably, the second portion 223-3 of the third metal layer 290 may have different thicknesses for each region. For example, the thickness of a region of the second portion 223-3 overlapping the second through electrode 232 in the third direction may be greater than the thickness of other regions.

As described above, the second through electrode 232 and the third electrode part 223 are composed of the second seed layer 270, the second metal layer 280 and the third metal layer 290.

The second through electrode 232 may include the first portion 232-1 of the second seed layer 270, the first portion 232-2 of the second metal layer 280 and the first portion 232-3 of the third metal layer 290.

For example, the third electrode part 223 may include the second portion 223-1 of the second seed layer 270, the second portion 223-2 of the second metal layer 280 and the second portion 223-3 of the third metal layer 290. In this case, the third electrode part 223 may have a different layer structure for each region. For example, the third electrode part 223 may include a first region overlapping the second through electrode 232 in a third direction (e.g. a thickness direction) and a second region other than the first region. Also, the first region of the third electrode part 223 may include only the first portion 232-3 of the third metal layer 290. In addition, the second region of the third electrode part 223 may include the second portion 223-1 of the second seed layer 270, the second portion 223-2 of the second metal layer 280 and the second portion 223-3 of the third metal layer 290. For example, the first region of the third electrode part 223 may have a one-layer structure, and the second region of the third electrode part 223 may have a three-layer structure.

Meanwhile, as described above, the first portion 232-2 of the second metal layer 280 may have different thicknesses for each region. For example, the first portion 232-2 of the second metal layer 280 may have a greatest thickness in an edge region of the second through hole and a smallest thickness in a central region of the second through hole.

In this case, the embodiment may adjust a position of a lowermost end of the upper surface of the first portion 232-2 of the second metal layer 280 by adjusting the current density of the primary plating process as described above. That is, a first thickness H1 may be provided between the lower surface of the first portion 232-2 of the second metal layer 280 and a lowermost end of the upper surface of the first portion 232-2 of the second metal layer 280. In addition, the embodiment can adjust the current density so that the first thickness H1 can be controlled, and accordingly, it is possible to remove the stain. The first thickness H1 may have a range of 30% to 95% of the width W2 of the second through electrode 232 in the second direction. For example, the first thickness H1 may have a range of 35% to 90% of the width W2 of the second through electrode 232 in the second direction. For example, the first thickness H1 may have a range of 40% to 85% of the width W2 of the second through electrode 232 in the second direction. When the first thickness H1 is less than 35% of the width W2 of the second through electrode 232 in the second direction, the time of the secondary plating process for forming the third metal layer 290 may increase. In addition, when the first thickness H1 is smaller than 35% of the width W2 of the second through electrode 232 in the second direction, it may be difficult to completely fill the dimple region with only the third metal layer 290. When the first thickness H1 is greater than 95% of the width W2 of the second through electrode 232 in the second direction, the time required to form the second metal layer 280 by the primary plating process increases, and thus yield may decrease. In addition, when the first thickness H1 is greater than 95% of the width W2 in the second direction, a portion of the third electrode part 223 may be composed of only the second portion 223-2 of the second metal layer 280, and this may cause the stain.

Meanwhile, the thickness H2 of the second through electrode 232 may correspond to the thickness of the second insulating layer 212. A thickness H2 of the second through electrode 232 may have a range of 10 µm to 200 µm. For example, the thickness H2 of the second through electrode 232 may have a range of 15 µm to 150 µm. For example, the thickness H2 of the second through electrode 232 may have a range of 20 µm to 120 µm.

In addition, the embodiment may adjust a height of the uppermost end of the second portion 223-2 of the second metal layer 280 constituting the third electrode part 223 by adjusting the current density for the primary plating process as described above. The height H3 of the uppermost end of the second portion 223-2 of the second metal layer 280 may refer to a thickness H3 from the lower surface of the second portion 223-1 of the second seed layer 270 to the uppermost end of the second portion 223-2 of the second metal layer 280. Also, the height H3 of the uppermost end of the second portion 223-2 of the second metal layer 280 may be determined by the thickness of the third electrode part 223. The thickness of the third electrode part 223 may mean a distance or height between the first surface of the second insulating layer 212 and the upper surface of the second portion 223-3 of the third metal layer 290. For example, the height H3 of the uppermost end of the second portion 223-2 of the second metal layer 280 may satisfy a range of 50% to 85% of the thickness of the third electrode part 223. For example, the height H3 of the uppermost end of the second portion 223-2 of the second metal layer 280 may satisfy a range of 52% to 80% of the thickness of the third electrode part 223. For example, the height H3 of the uppermost end of the second portion 223-2 of the second metal layer 280 may satisfy a range of 55% to 78% of the thickness of the third electrode part 223. When the height H3 of the uppermost end of the second portion 223-2 of the second metal layer 280 is less than 50% of the thickness of the third electrode part 223, an area of the dimple region of the second through electrode 232 increases, and thus the dimple region may not be completely filled with the second metal layer. In addition, when the height H3 of the uppermost end of the second portion 223-2 of the second metal layer 280 is greater than 85% of the thickness of the third electrode part 223, a stain may occur on the upper surface of the third electrode part 223.

As escribed above, in the embodiment, the primary plating and the secondary plating are performed to form the second metal layer 280 and the third metal layer 290 corresponding to the second through electrode 232 and the third electrode part 223. In addition, the embodiment completely removes the dimple region that may be included in the second through electrode 232 by adjusting the plating condition of the second metal layer 280. Therefore, the embodiment allows to remove the stain that may be formed on the surface of the third electrode part 223.

The third electrode part 223 may have a third thickness H6. The third electrode part 223 may be greater than the thicknesses of the first electrode part 221 and the second electrode part 222. That is, the third thickness H6 may be greater than the first thickness H4 and the second thickness H5.

The third thickness H6 may satisfy a range of 19 µm to 29 µm. For example, the third thickness H6 may satisfy a range of 21 µm to 27 µm. For example, the third thickness H6 may satisfy a range of 22 µm to 26 µm.

Meanwhile, the third electrode part 223 of the embodiment includes a first surface treatment layer 241.

The first surface treatment layer 241 may be formed on the second portion 223-3 of the third metal layer 290 of the third electrode part 223. In this case, the first surface treatment layer 241 may be formed only on the upper surface of the third electrode part 223. Alternatively, the first surface treatment layer 241 may be formed not only on the upper surface of the third electrode part 223 but also on the side surface.

The first surface treatment layer 241 may include a first-first surface treatment layer 241-1, a first-second surface treatment layer 241-2, and a first-third surface treatment layer 241-3.

The first-first surface treatment layer 241-1 may be formed on the third electrode part 223. The first-second surface treatment layer 241-2 may be formed on the first-first surface treatment layer 241-1. In addition, the first-third surface treatment layer 241-3 may be formed on the first-second surface treatment layer 241-2.

The first-first surface treatment layer 241-1 may include nickel (Ni). Accordingly, the first-first surface treatment layer 241-1 may be referred to as a nickel metal layer. The first-first surface treatment layer 241-1 may include only nickel or may be formed of an alloy including nickel and P (phosphorus), B (boron), W (tungsten), or Co (cobalt).

The first-first surface treatment layer 241-1 may have a thickness of 2 µm to 10 µm. For example, the first-first surface treatment layer 241-1 may have a thickness of 3 µm to 8 µm. For example, the first-first surface treatment layer 241-1 may have a thickness of 4 µm to 6 µm.

The first-second surface treatment layer 241-2 may include palladium (Pd). Accordingly, the first-second surface treatment layer 241-2 may be referred to as a palladium metal layer. The first-second surface treatment layer 241-2 may include only palladium, or may further include at least one metal selected from cobalt (Co), zinc (Zn), nickel (Ni), and an inorganic material in addition to palladium. The first-second surface treatment layer 241-2 may have a thickness of 0.001 µm to 0.5 µm. For example, the first-second surface treatment layer 241-2 may have a thickness of 0.005 µm to 0.2 µm. For example, the first-second surface treatment layer 241-2 may have a thickness of 0.01 µm to 0.1 µm.

The first-third surface treatment layer 241-3 may include gold (Au). The first-third surface treatment layer 241-3 may have a thickness of 0.001 µm to 0.5 µm. For example, the first-third surface treatment layer 241-3 may have a thickness of 0.005 µm to 0.2 µm. For example, the first-third surface treatment layer 241-3 may have a thickness of 0.01 µm to 0.1 µm.

The second embodiment includes the first through electrode 231 and the second electrode part 222 disposed on one side of the first electrode part 221 as described above. In addition, The second embodiment includes a second through electrode 232 and a third electrode part 223 disposed on one side of the second electrode part 222. At this time, the first through electrode 231 or the second electrode part 222 disposed inside includes a dimple region. Also, the second through electrode 232 disposed outside is formed to fill the dimple region of the first through electrode 231 or the second electrode part 222. Accordingly, the thickness of the third electrode part 223 of the embodiment may be greater than the thicknesses of the first electrode part 221 and the second electrode part 222, and the thickness of the second electrode part 222 may be smaller than the thickness of the first electrode part 221 and the third electrode part 223. Accordingly, the embodiment can simplify the process of forming a through electrode with a large area, thereby improving product yield.

FIGS. 10 to 22 are views for explaining a method of manufacturing a circuit board according to a second embodiment in order of process.

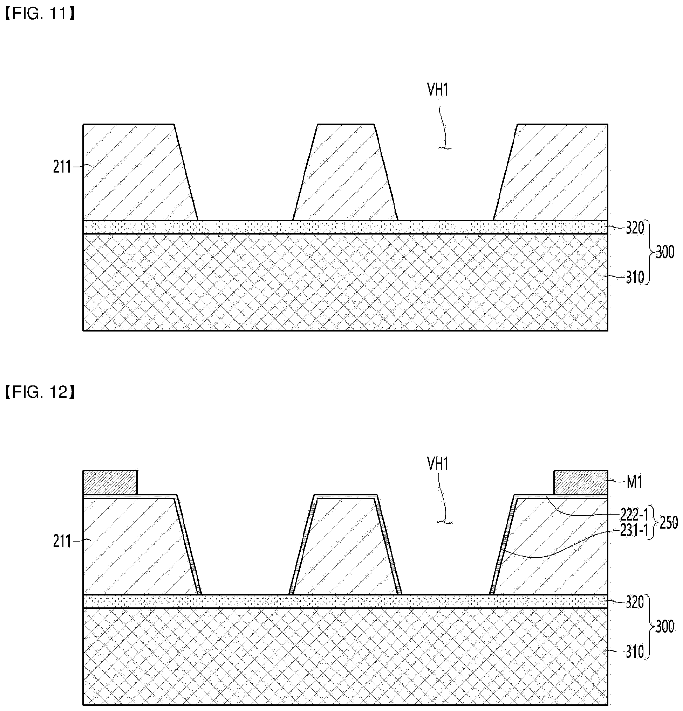

Referring to FIG. 10, in the embodiment, basic materials for manufacturing a circuit board are prepared. For example, in the embodiment, a carrier board 300 may be prepared. The carrier board 300 may include a carrier film 310 and a copper foil 320 formed on the carrier film 310. The copper foil 320 may be a copper foil bonded to the carrier film 310, but is not limited thereto. In addition, it is illustrated that the copper foil 320 is disposed on only one surface of the carrier film 310 in the drawings, but the embodiment is not limited thereto. For example, the copper foil 320 may also be disposed on the other surface of the carrier film 310. In addition, the processes of FIGS. 11 to 20 described below may be equally performed not only on one side of the carrier film 310 but also on the other side.

Referring to FIG. 11, the embodiment may proceed with a process of stacking a first insulating layer 211 on the first surface of the copper foil 320. When the first insulating layer 211 is stacked, the embodiment may proceed with a process of forming a plurality of first through holes VH1 in the first insulating layer 211. Each of the plurality of first through holes VH1 may have a bar shape elongated in a first direction (e.g. a longitudinal direction).

Referring to FIG. 12, the embodiment may proceed with a process of forming a first seed layer 250 on the first surface of the first insulating layer 211 and the inner wall of the first through hole VH1. The first seed layer 250 may be formed by chemical copper plating, but is not limited thereto.

The first seed layer 250 may include a first portion 231-1 formed on an inner wall of the first through hole VH1 and a second portion 222-1 formed on a first surface of the first insulating layer 211.

Next, the embodiment may proceed with a process of forming a first mask M1 on the first seed layer 250. The first mask M1 may include an opening (not shown) exposing a region overlapping the first through hole VH1 in a thickness direction.

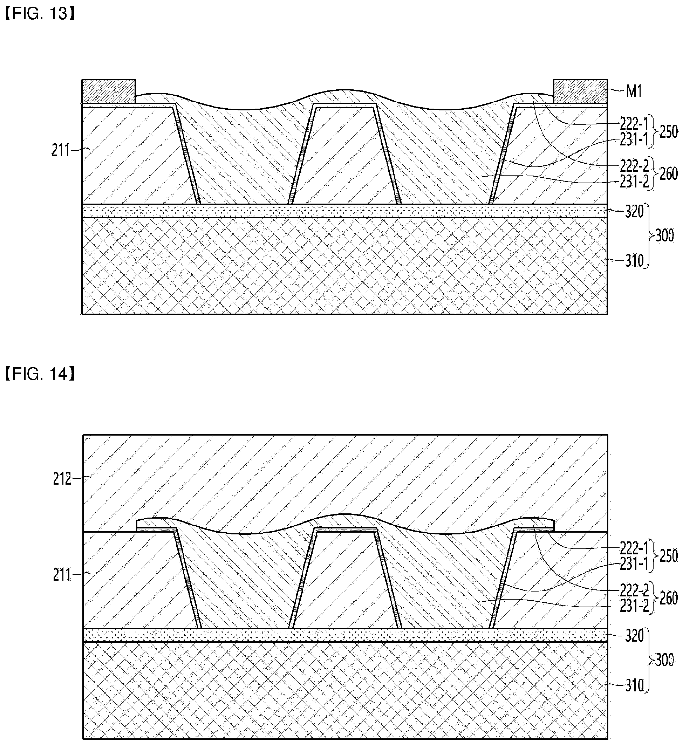

Referring to FIG. 13, the embodiment may proceed with a process of forming the second electrode part 222 and the first through electrode 231 by performing a process of forming the first metal layer 260 by plating in the region exposed through the opening of the first mask M1.

The first metal layer 260 may include a first portion 231-2 formed in the first through hole VH1 and a second portion 222-2 formed on the second portion 222-1 of the first seed layer 250. Accordingly, the first through electrode 231 includes the first portion 231-1 of the first seed layer 250 and the first portion 231-2 of the first metal layer 260. In addition, the second electrode part 222 includes the second portion 222-1 of the first seed layer 250 and the second portion 222-2 of the first metal layer 260. In this case, the second portion 222-2 of the first metal layer 260 may include a concave portion. For example, an upper surface of the second portion 222-2 of the first metal layer 260 may include a curved surface. An upper surface of the second portion 222-2 of the first metal layer 260 corresponds to an upper surface of the second electrode part 222. Accordingly, the upper surface of the second electrode part 222 may include a concave portion or a curved surface.

Next, referring to FIG. 14, the embodiment may proceed with a process of removing the first mask M1.

Then, when the first mask M1 is removed, the embodiment may proceed with a process of removing the first seed layer 250. Specifically, the embodiment may proceed with a process of removing a portion of the first seed layer 250 that does not overlap with the first metal layer 260 in the thickness direction.

In addition, when the first seed layer 250 is removed, the embodiment may proceed with a process of stacking a second insulating layer 212 on the first surface of the first insulating layer 211.

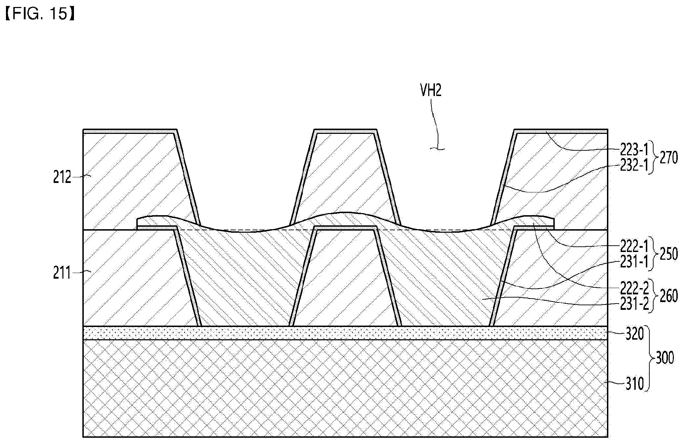

Next, referring to FIG. 15, the embodiment may proceed with a process of forming a plurality of second through holes VH2 in the second insulating layer 212. In this case, the second through hole VH2 may expose an upper surface of the first through electrode 231 or the second electrode part 222. Then, when the second through hole VH2 is formed, the embodiment may proceed a process of forming the second seed layer 270 on the inner wall of the second through hole VH2 and the first surface of the second insulating layer 212.

The second seed layer 270 may be a seed layer for forming the second metal layer 280 and the third metal layer 290 constituting the second through electrode 232 and the third electrode part 223 by electrolytic plating. The second seed layer 270 may be formed on a first surface of the second insulating layer 212 and an inner wall of a second through hole VH2 formed in the second insulating layer 212.

The second seed layer 270 may include a first portion 232-1 formed on the inner wall of the second through hole VH2 and a second portion 223-1 formed on the first surface of the second insulating layer 212.

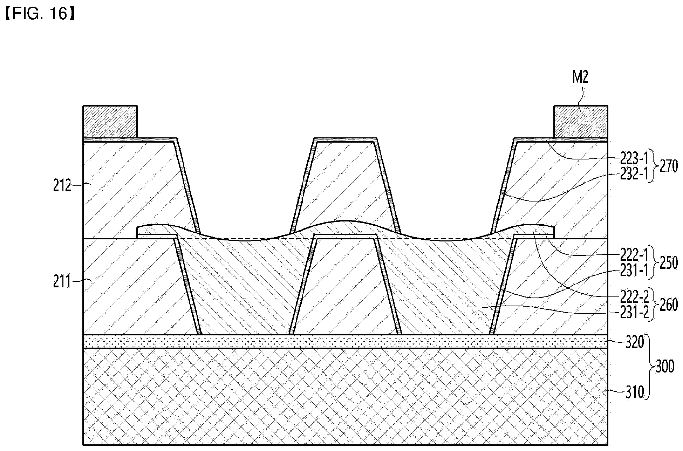

Next, referring to FIG. 16, the embodiment may proceed with a process of forming a second mask M2 on the second seed layer 270.

The second mask M2 may include an opening (not shown) formed in a region overlapping the second through hole VH2 in a thickness direction.

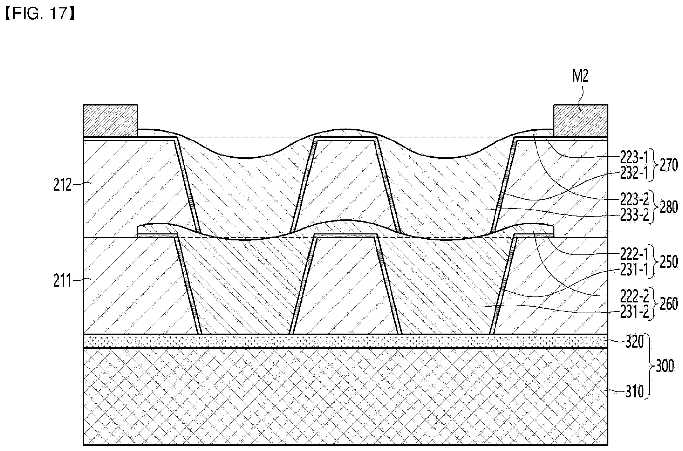

Next, referring to FIG. 17, the embodiment may proceed with a process of forming a second metal layer 280 by performing primary electroplating using the second seed layer 270.

The second metal layer 280 may include a first portion 232-2 formed on the first portion 232-1 of the second seed layer 270 and a second portion 223-2 formed on the second portion 223-1 of the second seed layer 270.

The first portion 232-2 of the second metal layer 280 may constitute the second through electrode 232. Also, the second portion 223-2 of the second metal layer 280 may constitute the third electrode part 223. For example, the first portion 232-2 of the second metal layer 280 may partially fill the second through hole. Also, the second portion 223-2 of the second metal layer 280 may be formed to have a predetermined height above the second portion 223-1 of the second seed layer 270. In this case, the first portion 232-2 of the second metal layer 280 may include a convex portion. For example, the lower surface of the first portion 232-2 of the second metal layer 280 may have a convex curved surface in a downward direction. For example, the first portion 232-2 of the second metal layer 280 may include an upper surface corresponding to a concave portion of the upper surface of the first electrode part 221. A lowermost end of the first portion 232-2 of the second metal layer 280 (lowermost end of the second through electrode 232 ) may be positioned lower than an uppermost end of the first electrode part 221.

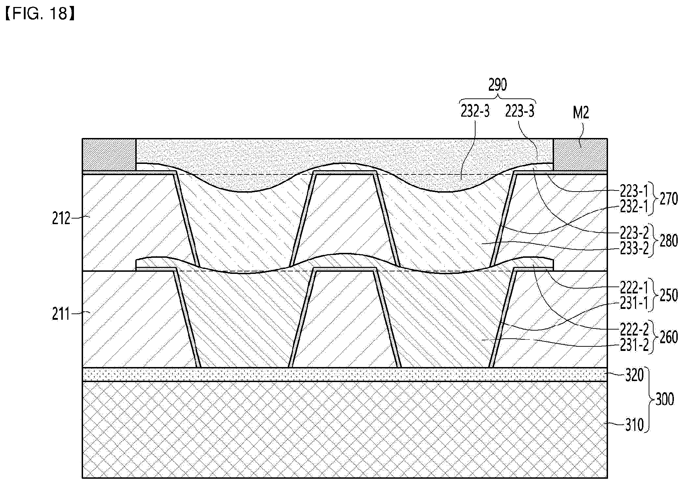

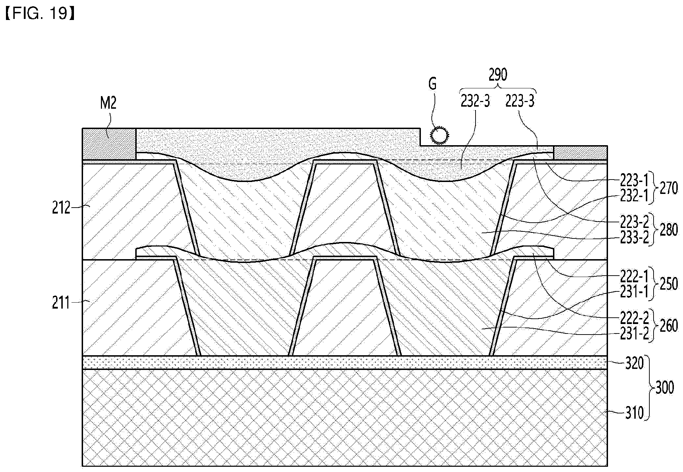

Next, referring to FIG. 18, the embodiment may proceed with a process of forming a third metal layer 290 on the second metal layer 280. The third metal layer 290 may be formed on the second metal layer 280 by electroplating the second seed layer 270. At this time, a thickness of the third metal layer 290 is greater than a thickness of the third electrode part 223 of the embodiment, and accordingly, the embodiment may proceed with a process of flattening the upper surface of the third metal layer 290 by performing grinding using a grinder G as shown in FIG. 19.

Accordingly, the third metal layer 290 may include a first portion 232-3 formed on the first portion 232-2 of the second metal layer 280 and a second portion 223-3 formed on the second portion 223-2 of the second metal layer 280.

The first portion 232-3 of the third metal layer 290 may fill the concave portion of the first portion 232-2 of the second metal layer 280. For example, the lower surface of the first portion 232-3 of the third metal layer 290 may include a convex portion. For example, the lower surface of the first portion 232-3 of the third metal layer 290 may have a convex curved surface in a downward direction. In this case, the lowermost end of the lower surface of the first portion 232-3 of the third metal layer 290 may be positioned lower than the first surface of the second insulating layer 212.

Accordingly, the embodiment may proceed with a process of forming the second through electrode 232 and the third electrode part 223 by forming the second seed layer 270, the second metal layer 280 and the third metal layer 290. For example, the second through electrode 232 may include the first portion 232-1 of the second seed layer 270, the first portion 232-2 of the second metal layer 280 and the first portion 232-3 of the third metal layer 290. For example, the third electrode part 223 may include the second portion 223-1 of the second seed layer 270, the second portion 223-2 of the second metal layer 280 and the second portion 223-3 of the third metal layer 290.

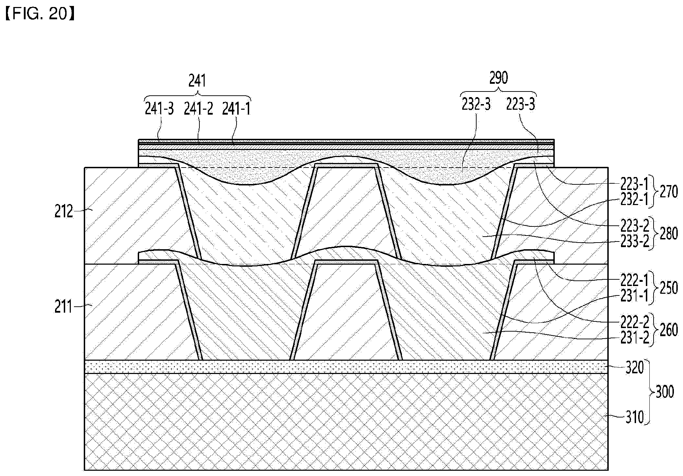

Next, as shown in FIG. 20, the embodiment may proceed with a process of forming the first surface treatment layer 241 on the third electrode part 223.

The first surface treatment layer 241 may be formed on the second portion 223-3 of the third metal layer 290 of the third electrode part 223. In this case, the first surface treatment layer 241 may be formed only on the upper surface of the third electrode part 223. Alternatively, the first surface treatment layer 241 may be formed not only on the upper surface of the third electrode part 223 but also on the side surface.

Specifically, the embodiment may proceed with a process of sequentially forming the first-first surface treatment layer 241-1, the first-second surface treatment layer 241-2 and the first-third surface treatment layer 241-3 on the third electrode part 223.

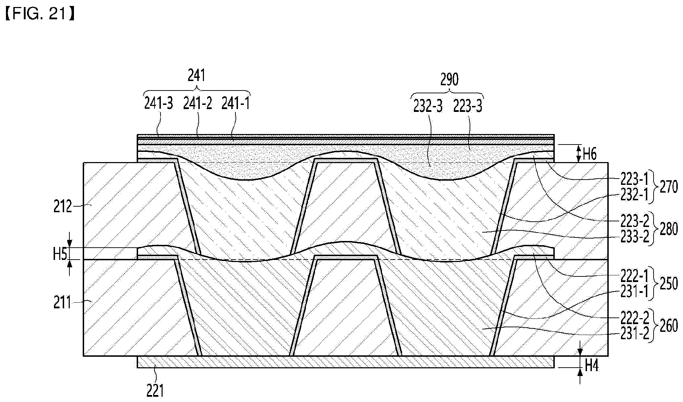

Next, referring to FIG. 21, the embodiment may proceed with a process of removing the carrier board 300 and forming a first electrode part 221 on the second surface of the first insulating layer 211. The first electrode part 221 may be formed using the copper foil 320 constituting the carrier board 300, but is not limited thereto. Meanwhile, in an embodiment, a process of forming the first electrode part 221 on the carrier board 300 may be performed before forming the first insulating layer 211 of FIG. 11.

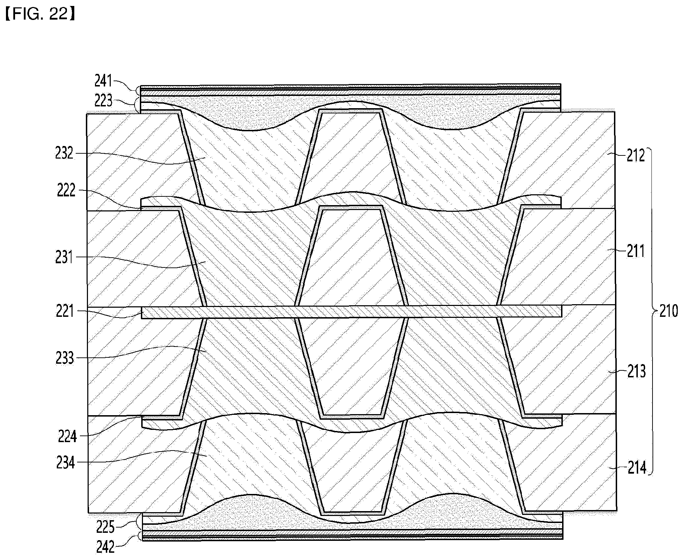

Next, referring to FIG. 22, the embodiment may proceed with a process of forming a second substrate layer on the other side of the first electrode part 221 corresponding to the first substrate layer formed on one side of the first electrode part 221.

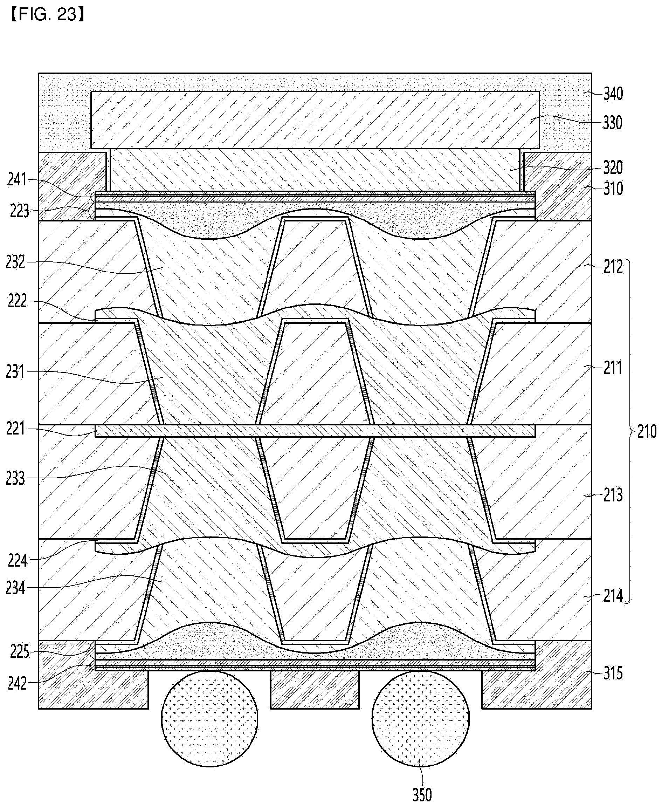

FIG. 23 is a view illustrating a semiconductor package according to an embodiment.

Referring to FIG. 23, the semiconductor package may include the circuit board shown in FIG. 4 or 7.

Meanwhile, the circuit board may include a protective layer. For example, the circuit board may include a first protective layer 310 formed on the first surface of the second insulating layer 212 and including an opening (not shown) exposing the first surface treatment layer 241. For example, the circuit board may include a second protective layer 315 formed on the second surface of the fourth insulating layer 214 and including an opening (not shown) exposing the second surface treatment layer 242.

Specifically, the semiconductor package may include a first adhesive member 320 disposed on the first surface treatment layer 241 exposed through the opening of the first protective layer 310 of the circuit board. In addition, the semiconductor package may include a second adhesive member 350 disposed on the second surface treatment layer 242 of the circuit board.

The first adhesive member 320 and the second adhesive member 350 may have different shapes. For example, the first adhesive member 320 may have a hexahedral shape. For example, a cross section of the first adhesive member 320 may include a rectangular shape. For example, the cross section of the first adhesive member 320 may have a rectangular or square shape. The second adhesive member 320 may have a spherical shape. For example, the cross section of the second adhesive member 350 may include a circular shape or a semicircular shape. For example, the cross section of the second adhesive member 350 may have a partially or entirely rounded shape. For example, the cross section of the second adhesive member 350 may include a flat surface on one side and a curved surface on the other side opposite to the one side. Meanwhile, the second adhesive member 350 may be a solder ball, but is not limited thereto.

A chip 330 may be mounted on the first adhesive member 320. For example, the chip 330 may include a drive IC chip. For example, the chip 330 may mean various chips including sockets or devices other than a drive IC chip. For example, the chip 330 may include at least one of a diode chip, a power IC chip, a touch sensor IC chip, an MLCC chip, a BGA chip, and a chip capacitor. For example, the chip 330 may be a power management integrated circuit (PMIC). For example, the chip 330 may be a memory chip such as a volatile memory (e.g. DRAM), a nonvolatile memory (e.g. ROM), or a flash memory. For example, the chip 330 may be an application processor (AP) chip such as a central processor (e.g., CPU), a graphic processor (e.g., GPUs), a digital signal processor, a cryptographic processor, a microprocessor, and microcontroller, etc., or a logic chip such as an analog-to-digital converter or an application-specific IC (ASIC).

Here, it is illustrated that only one chip is mounted in a semiconductor package in the drawings, but it is not limited thereto. The semiconductor package may include a plurality of chips, and the plurality of chips may include a first AP chip corresponding to a central processor (CPU) and a second AP chip corresponding to a graphic processor (GPU).

A molding layer 340 may be formed on the circuit board. The molding layer 340 may be disposed to cover the mounted chip 330. For example, the molding layer 340 may be EMC (Epoxy Mold Compound) formed to protect the mounted chip 330, but is not limited thereto.

An embodiment includes a through electrode passing through the insulating layer. In this case, in an embodiment, a plurality of plating processes are performed to fill a through hole passing through the insulating layer. Through this, the embodiment forms a through electrode that fills a through hole with a large area.

In this case, the embodiment adjusts the current density, which is the plating condition of the plurality of plating processes. Through this, the embodiment forms a first metal layer of a primary plating process and a second metal layer of the secondary plating process constituting each part of a through electrode and a first electrode part. In this case, the first metal layer of the embodiment may be formed with a relatively low current density, and the second metal layer may be formed with a relatively high current density. Accordingly, in the circuit board including a large-area through electrode, the dimple region can be prevented from being included in the through electrode or the first electrode part. Through this, the embodiment can improve product reliability.

In addition, the embodiment allows the upper surface of the first pad to be formed only of the second metal layer through the control of the current density as described above. Accordingly, the embodiment can solve the stain problem due to the upper surface of the first electrode part including both the first and second metal layers, and thereby improve customer satisfaction. In addition, the embodiment can solve the increase in plating time due to the upper surface of the first electrode part including only the first metal layer, thereby improving product yield.

In addition, another embodiment includes a first through electrode and a second electrode part disposed on one side of the first electrode part. In addition, the embodiment includes a second through electrode and a third electrode part disposed on one side of the second electrode part. In this case, the first through electrode or the second electrode part disposed inside includes a dimple region. The second through electrode disposed outside is formed to fill the dimple region of the first through electrode or the second electrode part. Accordingly, in the embodiment, the third electrode part has a thickness thicker than the first electrode part and the second electrode part, and the second electrode part may have a thickness smaller than that of the first electrode part and the third electrode part. Accordingly, the embodiment can simplify the process of forming a through electrode with a large area, thereby improving product yield.

## Claims

1. A circuit board comprising:
a first electrode part;
a first insulating layer disposed on an upper surface of the first electrode part;
a second electrode part disposed on an upper surface of the first insulating layer;
a first through electrode passing through the first insulating layer;
a second insulating layer disposed on the upper surface of the first insulating layer;
a third electrode part disposed on an upper surface of the second insulating layer;
and
a second through electrode passing through the second insulating layer;
wherein a thickness of the first electrode part is thicker than a thickness of the second electrode part, and
wherein a thickness of the third electrode part is greater than a thickness of each of the first electrode part and the second electrode part;
**characterized in that**
the second electrode part includes a first portion overlapping the first through electrode in a vertical direction and a second portion that does not overlap the first through electrode in the vertical direction,
wherein an upper surface of the first portion of the second electrode part has a concave surface that is concave toward the first through electrode, and
wherein an upper surface of the second portion of the second electrode part has a convex surface that is convex toward the second insulating layer.

2. The circuit board of claim 1, wherein the third electrode part includes a concave surface overlapping the second through electrode in the vertical direction and concave toward the second through electrode.

3. The circuit board of claim 2, wherein a lower surface of the second through electrode includes a convex surface contacting the upper surface of the first portion of the second electrode part.

4. The circuit board of claim 1, wherein a first height between a lowermost end of the concave surface of the second electrode part and a lower surface of the first insulating layer is smaller than a second height between an upper surface of the first insulating layer and the lower surface of the first insulating layer.

5. The circuit board of claim 1, wherein a plurality of first through electrodes are provided while being spaced apart from each other in a horizontal direction.

6. The circuit board of claim 5, wherein the convex surface of the second portion of the second electrode part overlaps a separation region between the plurality of first through electrodes in the vertical direction.

7. The circuit board of claim 5, wherein a plurality of second through electrodes are provided while being spaced apart from each other in the horizontal direction

8. The circuit board of claim 7, wherein the plurality of first through electrodes and the plurality of second through electrodes are interconnected through the second electrode part.

9. The circuit board of claim 2, wherein a curvature of the concave surface of the first portion of the second electrode part is different from a curvature of the concave surface of the third electrode part.

10. The circuit board of claim 3, wherein a first depth from the upper surface of the first insulating layer to a lowermost end of the concave surface of the first portion of the second electrode part is different from a second depth from an upper surface of the second insulating layer to a lowermost end of the concave surface of the third electrode part.

11. The circuit board of claim 10, wherein the second depth is greater than the first depth.

12. The circuit board of claim 3, wherein an uppermost end of the convex surface of the second portion of the second electrode part is positioned higher than a lowest end of the convex surface of the second through electrode.

13. The circuit board of claim 10, wherein a lowermost end of the convex surface of the second through electrode is positioned lower than an upper surface of the first insulating layer.

## Patentansprüche

1. Leiterplatte, umfassend:
ein erstes Elektrodenteil;
eine erste Isolierschicht, die auf einer oberen Oberfläche des ersten Elektrodenteils angeordnet ist;
ein zweites Elektrodenteil, das auf einer oberen Oberfläche der ersten Isolierschicht angeordnet ist;
eine erste Durchgangselektrode, die durch die erste Isolierschicht verläuft;
eine zweite Isolierschicht, die auf der oberen Oberfläche der ersten Isolierschicht angeordnet ist;
ein drittes Elektrodenteil, das auf einer oberen Oberfläche der zweiten Isolierschicht angeordnet ist; und
eine zweite Durchgangselektrode, die durch die zweite Isolierschicht verläuft;
wobei eine Dicke des ersten Elektrodenteils dicker ist als eine Dicke des zweiten Elektrodenteils, und
wobei eine Dicke des dritten Elektrodenteils größer ist als eine Dicke jeweils des ersten Elektrodenteils und des zweiten Elektrodenteils;
**dadurch gekennzeichnet, dass**
das zweite Elektrodenteil einen ersten Abschnitt enthält, der die erste Durchgangselektrode in einer vertikalen Richtung überlappt, und einen zweiten Abschnitt, der die erste Durchgangselektrode in der vertikalen Richtung nicht überlappt,
wobei eine obere Oberfläche des ersten Abschnitts des zweiten Elektrodenteils eine konkave Oberfläche aufweist, die in Richtung der ersten Durchgangselektrode konkav ist, und
wobei eine obere Oberfläche des zweiten Abschnitts des zweiten Elektrodenteils eine konvexe Oberfläche aufweist, die in Richtung der zweiten Isolierschicht konvex ist.

2. Leiterplatte nach Anspruch 1, wobei das dritte Elektrodenteil eine konkave Oberfläche enthält, die die zweite Durchgangselektrode in vertikaler Richtung überlappt und in Richtung der zweiten Durchgangselektrode konkav ist.

3. Leiterplatte nach Anspruch 2, wobei eine untere Oberfläche der zweiten Durchgangselektrode eine konvexe Oberfläche enthält, die die obere Oberfläche des ersten Abschnitts des zweiten Elektrodenteils berührt.

4. Leiterplatte nach Anspruch 1, wobei eine erste Höhe zwischen einem untersten Ende der konkaven Oberfläche des zweiten Elektrodenteils und einer unteren Oberfläche der ersten Isolierschicht kleiner ist als eine zweite Höhe zwischen einer oberen Oberfläche der ersten Isolierschicht und der unteren Oberfläche der ersten Isolierschicht.

5. Leiterplatte nach Anspruch 1, wobei eine Vielzahl von ersten Durchgangselektroden vorgesehen sind, die gleichzeitig in horizontaler Richtung voneinander beabstandet sind.

6. Leiterplatte nach Anspruch 5, wobei die konvexe Oberfläche des zweiten Abschnitts des zweiten Elektrodenteils einen Trennbereich zwischen der Vielzahl von ersten Durchgangselektroden in vertikaler Richtung überlappt.

7. Leiterplatte nach Anspruch 5, wobei eine Vielzahl von zweiten Durchgangselektroden vorgesehen sind, die gleichzeitig in horizontaler Richtung voneinander beabstandet sind.

8. Leiterplatte nach Anspruch 7, wobei die Vielzahl von ersten Durchgangselektroden und die Vielzahl von zweiten Durchgangselektroden durch das zweite Elektrodenteil miteinander verbunden sind.

9. Leiterplatte nach Anspruch 2, wobei sich eine Krümmung der konkaven Oberfläche des ersten Abschnitts des zweiten Elektrodenteils von einer Krümmung der konkaven Oberfläche des dritten Elektrodenteils unterscheidet.

10. Leiterplatte nach Anspruch 3, wobei sich eine erste Tiefe von der oberen Oberfläche der ersten Isolierschicht zu einem untersten Ende der konkaven Oberfläche des ersten Abschnitts des zweiten Elektrodenteils von einer zweiten Tiefe von einer oberen Oberfläche der zweiten Isolierschicht zu einem untersten Ende der konkaven Oberfläche des dritten Elektrodenteils unterscheidet.

11. Leiterplatte nach Anspruch 10, wobei die zweite Tiefe größer ist als die erste Tiefe.

12. Leiterplatte nach Anspruch 3, wobei ein oberstes Ende der konvexen Oberfläche des zweiten Abschnitts des zweiten Elektrodenteils höher als ein unterstes Ende der konvexen Oberfläche der zweiten Durchgangselektrode positioniert ist.

13. Leiterplatte nach Anspruch 10, wobei ein unterstes Ende der konvexen Oberfläche der zweiten Durchgangselektrode niedriger als eine obere Oberfläche der ersten Isolierschicht positioniert ist.

## Revendications

1. Carte de circuit imprimé comprenant :
une première partie d'électrode ;
une première couche isolante disposée sur une surface supérieure de la première partie d'électrode ;
une deuxième partie d'électrode disposée sur une surface supérieure de la première couche isolante ;
une première électrode traversante traversant la première couche isolante ;
une deuxième couche isolante disposée sur la surface supérieure de la première couche isolante ;
une troisième partie d'électrode disposée sur une surface supérieure de la deuxième couche isolante ; et
une deuxième électrode traversante traversant la deuxième couche isolante ;
dans laquelle une épaisseur de la première partie d'électrode est plus épaisse qu'une épaisseur de la deuxième partie d'électrode, et
dans laquelle une épaisseur de la troisième partie d'électrode est supérieure à une épaisseur de chacune de la première partie d'électrode et de la deuxième partie d'électrode ;
**caractérisée en ce que**
la deuxième partie d'électrode comporte une première portion chevauchant la première électrode traversante dans une direction verticale et une deuxième portion ne chevauchant pas la première électrode traversante dans la direction verticale,
dans laquelle une surface supérieure de la première portion de la deuxième partie d'électrode présente une surface concave qui est concave vers la première électrode traversante, et
dans laquelle une surface supérieure de la deuxième portion de la deuxième partie d'électrode présente une surface convexe qui est convexe vers la deuxième couche isolante.

2. Carte de circuit imprimé selon la revendication 1, dans laquelle la troisième partie d'électrode comporte une surface concave chevauchant la deuxième électrode traversante dans la direction verticale et concave vers la deuxième électrode traversante.

3. Carte de circuit imprimé selon la revendication 2, dans laquelle une surface inférieure de la deuxième électrode traversante comporte une surface convexe en contact avec la surface supérieure de la première portion de la deuxième partie d'électrode.

4. Carte de circuit imprimé selon la revendication 1, dans laquelle une première hauteur entre une extrémité la plus basse de la surface concave de la deuxième partie d'électrode et une surface inférieure de la première couche isolante est inférieure à une deuxième hauteur entre une surface supérieure de la première couche isolante et la surface inférieure de la première couche isolante.

5. Carte de circuit imprimé selon la revendication 1, dans laquelle une pluralité de premières électrodes traversantes sont fournies tout en étant espacées les unes des autres dans une direction horizontale.

6. Carte de circuit imprimé selon la revendication 5, dans laquelle la surface convexe de la deuxième portion de la deuxième partie d'électrode chevauche une région de séparation entre la pluralité de premières électrodes traversantes dans la direction verticale.

7. Carte de circuit imprimé selon la revendication 5, dans laquelle une pluralité de deuxièmes électrodes traversantes sont fournies tout en étant espacées les unes des autres dans la direction horizontale.

8. Carte de circuit imprimé selon la revendication 7, dans laquelle la pluralité de premières électrodes traversantes et la pluralité de deuxièmes électrodes traversantes sont interconnectées à travers la deuxième partie d'électrode.

9. Carte de circuit imprimé selon la revendication 2, dans laquelle une courbure de la surface concave de la première portion de la deuxième partie d'électrode est différente d'une courbure de la surface concave de la troisième partie d'électrode.

10. Carte de circuit imprimé selon la revendication 3, dans laquelle une première profondeur depuis la surface supérieure de la première couche isolante jusqu'à une extrémité la plus basse de la surface concave de la première portion de la deuxième partie d'électrode est différente d'une deuxième profondeur depuis une surface supérieure de la deuxième couche isolante jusqu'à une extrémité la plus basse de la surface concave de la troisième partie d'électrode.

11. Carte de circuit imprimé selon la revendication 10, dans laquelle la deuxième profondeur est supérieure à la première profondeur.

12. Carte de circuit imprimé selon la revendication 3, dans laquelle une extrémité la plus haute de la surface convexe de la deuxième portion de la deuxième partie d'électrode est positionnée plus haut qu'une extrémité la plus basse de la surface convexe de la deuxième électrode traversante.

13. Carte de circuit imprimé selon la revendication 10, dans laquelle une extrémité la plus basse de la surface convexe de la deuxième électrode traversante est positionnée plus bas qu'une surface supérieure de la première couche isolante.
